# EUROPEAN PATENT APPLICATION

(11) **EP 4 456 139 A1**
(43) Date of publication of application: **30.10.2024**
(21) Application number: 22947133.9
(22) Date of filing: 20.06.2022
(51) Int. Cl.: H01L 27/15, H01L 33/50

(54) **CHIP STRUCTURE AND MANUFACTURING METHOD THEREFOR, DISPLAY SUBSTRATE, AND DISPLAY DEVICE**

(71) Applicant: Boe Technology Group Co., Ltd., Beijing 100015 (CN)
(72) Inventor: LI, Wei, Beijing 100176 (CN); WANG, Mingxing, Beijing 100176 (CN); ZHANG, Xiao, Beijing 100176 (CN); XUAN, Minghua, Beijing 100176 (CN); ZHANG, Can, Beijing 100176 (CN); WANG, Can, Beijing 100176 (CN); ZHANG, Dongliang, Beijing 100176 (CN); JIN, Qian, Beijing 100176 (CN); LI, Xiang, Beijing 100176 (CN); ZHANG, Jingjing, Beijing 100176 (CN); NIU, Jinfei, Beijing 100176 (CN)
(74) Representative: Hoffmann Eitle
(86) International application number: PCT/CN2022/099909
(87) International publication number: WO 2023/245352

(57) **Abstract**

A chip structure (10). The chip structure (10) comprises: a chip wafer unit (11) and a color conversion layer unit (21) provided on a light exit side (G) of the chip wafer unit (11), wherein the chip wafer unit (11) comprises a plurality of sub-pixel light-emitting functional layers (12, 12a, 12b, 12c), and the color conversion layer unit (21) comprises color conversion layers (22, 22a, 22b, 22c) provided on the light exit side (G) of the chip wafer unit (11). The chip structure (10) further comprises: bonding layers (13, 131, 133, 132), the bonding layers being provided between the chip wafer unit (11) and the color conversion layer unit (21) and used for bonding the chip wafer unit (11) and the color conversion layer unit (21).

## Description

### TECHNICAL FIELD

The present disclosure relates to the field of display technologies, and in particular, to a chip structure and a manufacturing method therefor, a display substrate, and a display device.

### BACKGROUND

As a new generation display technology, Micro-LED (Micrometer-sized light-emitting diode) display elements have many advantages such as high brightness, high luminescence efficiency, low power consumption, and fast response speed. However, in a case of applying the Micro-LED for display devices, there are still some problems such as a mass transfer problem, and product yield problem.

### SUMMARY

In an aspect, a chip structure is provided. The chip structure includes: a chip wafer unit and a color conversion layer unit arranged on a light-exit side of the chip wafer unit. The chip wafer unit includes: a plurality of sub-pixel light-emitting function layers. The color conversion layer unit includes: color conversion layers arranged on the light-exit side of the chip wafer unit. The chip structure further includes: an attaching layer, arranged between the chip wafer unit and the color conversion layer unit and configured to attach the chip wafer unit and the color conversion layer unit.

In some embodiments, the attaching layer is any one of an indium zinc oxide bonding layer, a metal bonding layer, and an adhesive glue layer.

In some embodiments, a dimension of the attaching layer in a first direction is less than a distance between two adjacent sub-pixel light-emitting function layers in the plurality of sub-pixel light-emitting function layers. The first direction is a direction from the chip wafer unit to the color conversion layer unit.

In some embodiments the attaching layer is the indium zinc oxide bonding layer, and a dimension of the indium zinc oxide bonding layer in the first direction is in a range of 100 nm to 300 nm, inclusive; or the attaching layer is the metal bonding layer, and a dimension of the metal bonding layer in the first direction is in a range of 6 µm to 12 µm, inclusive; or the attaching layer is the adhesive glue layer, and a dimension of the adhesive glue layer in the first direction is in a range of 5 µm to 10 µm, inclusive.

In some embodiments, the attaching layer is the indium zinc oxide bonding layer, the indium zinc oxide bonding layer includes: a first indium zinc oxide layer and a second indium zinc oxide layer that are arranged in a stack along the first direction, and the first indium zinc oxide layer is connected to the second indium zinc oxide layer through a bonding interaction of molecular bonds; or the attaching layer is the metal bonding layer, the metal bonding layer includes: a first metal sub-layer, a second metal sub-layer, and a third metal sub-layer that are arranged in a stack along the first direction, and the second metal sub-layer is a eutectic alloy layer connecting the first metal sub-layer and the third metal sub-layer. The first direction is a direction from the chip wafer unit to the color conversion layer unit.

In some embodiments, the attaching layer is the indium zinc oxide bonding layer, and an orthographic projection of the indium zinc oxide bonding layer on the plurality of sub-pixel light-emitting function layers covers the plurality of sub-pixel light-emitting function layers; or the attaching layer is the metal bonding layer, and the metal bonding layer is provided therein with opening zones corresponding to the plurality of sub-pixel light-emitting function layers; or the attaching layer is the adhesive glue layer, and an orthographic projection of the adhesive glue layer on the plurality of sub-pixel light-emitting function layers covers the plurality of sub-pixel light-emitting function layers.

In some embodiments, the chip structure further includes: a first substrate. The first substrate is arranged on a side of the color conversion layer unit away from the chip wafer unit, and an orthographic projection of the color conversion layer unit on the first substrate covers an orthographic projection of the attaching layer on the first substrate. A distance between a border of the orthographic projection of the color conversion layer unit on the first substrate and a border of the orthographic projection of the attaching layer on the first substrate is in a range of 0 µm to 10 µm, inclusive.

In some embodiments, each sub-pixel light-emitting function layer of the plurality of sub-pixel light-emitting function layers includes: an anode electrode, a current spreading layer, a p-type gallium nitride layer and a quantum well layer that are arranged in a stack along a first direction. The chip wafer unit further includes: a common cathode layer, the common cathode layer includes: a cathode electrode and a cathode metal layer that are arranged in a stack along the first direction. The cathode metal layer further includes: portions each located between two adjacent sub-pixel light-emitting function layers; the first direction is a direction from the chip wafer unit to the color conversion layer unit.

In some embodiments, a portion of the cathode metal layer located between two adjacent sub-pixel light-emitting function layers and the two adjacent sub-pixel light-emitting function layers have a distance therebetween; and the distance between the sub-pixel light-emitting function layers and the cathode metal layer is in a range of one tenth (1/10) to one third (1/3) of a distance between the two adjacent sub-pixel light-emitting function layers, inclusive.

In some embodiments, in a plurality of anode electrodes, a range of a distance between two adjacent anode electrodes is less than or equal to a range of a distance between two sub-pixel light-emitting function layers where the two anode electrodes are located.

In some embodiments, the chip wafer unit further includes: an n-type gallium nitride layer and a gallium nitride buffer layer that are arranged in a stack along a first direction; the n-type gallium nitride layer is arranged on a light-exit side of the plurality of sub-pixel light-emitting function layers; and the attaching layer is arranged on a side of the gallium nitride buffer layer away from the n-type gallium nitride layer; the first direction is a direction from the chip wafer unit to the color conversion layer unit.

In some embodiments, the plurality of sub-pixel light-emitting function layers include: a first sub-pixel light-emitting function layer, a second sub-pixel light-emitting function layer, and a third sub-pixel light-emitting function layer. The chip structure further includes: a first substrate, and the color conversion layer unit includes: a color filter layer arranged on a side of the first substrate; the color filter layer includes: a black matrix layer and a plurality of light-filtering film layers defined by the black matrix layer; the plurality of light-filtering film layers include: a first light-filtering film layer, a second light-filtering film layer, and a third light-filtering film layer, the first light-filtering film layer is arranged to correspond to the first sub-pixel light-emitting function layer, the second light-filtering film layer is arranged to correspond to the second sub-pixel light-emitting function layer, and the third light-filtering film layer is arranged to correspond to the third sub-pixel light-emitting function layer.

The color conversion layer unit further includes: a defining dam layer arranged on a side of the color filter layer away from the first substrate; the defining dam layer includes: a plurality of opening zones; the plurality of opening zones include: a first opening zone, a second opening zone, and a third opening zone, the first opening zone is arranged to correspond to the first sub-pixel light-emitting function layer, the second opening zone is arranged to correspond to the second sub-pixel light-emitting function layer, and the third opening zone is arranged to correspond to the third sub-pixel light-emitting function layer.

The color conversion layers further include: a first quantum dot conversion part, a second quantum dot conversion part and a scattering particle part, the first quantum dot conversion part is arranged in the first opening zone, the scattering particle part is arranged in the second opening zone, and the second quantum dot conversion part is arranged in the third opening zone.

In some embodiments, an orthographic projection of a light-filtering film layer on the first substrate covers an orthographic projection of a sub-pixel light-emitting function layer corresponding to the light-filtering film layer on the first substrate; an orthographic projection of a quantum dot conversion part on the first substrate covers an orthographic projection of a light-filtering film layer corresponding to the quantum dot conversion part on the first substrate; and an orthographic projection of the scattering particle part on the first substrate covers an orthographic projection of the second light-filtering film layer on the first substrate.

In some embodiments, a distance between a border of the orthographic projection of the light-filtering film layer on the first substrate and a border of the orthographic projection of the sub-pixel light-emitting function layer corresponding to the light-filtering film layer on the first substrate is in a range of 20 µm to 60 µm, inclusive; a distance between a border of the orthographic projection of the quantum dot conversion part on the first substrate and a border of the orthographic projection of the light-filtering film layer corresponding to the quantum dot conversion part on the first substrate is in a range of 23 µm to 68 µm, inclusive; and a distance between a border of the orthographic projection of the scattering particle part on the first substrate and a border of the orthographic projection of the second light-filtering film layer on the first substrate is in a range of 23 µm to 68 µm, inclusive.

In some embodiments, a dimension of the defining dam layer in a first direction is in a range of 10 µm to 30 µm, inclusive. The first direction is a direction from the chip wafer unit to the color conversion layer unit.

In another aspect, a manufacturing method for a chip structure is provided. The manufacturing method includes: forming an initial chip wafer unit, the initial chip wafer unit includes a temporary substrate, a plurality of sub-pixel light-emitting function layers, an n-type gallium nitride layer and a gallium nitride buffer layer that are arranged in a stack; forming a color conversion layer unit on an initial first substrate; and attaching the color conversion layer unit to a light-exit side of the initial chip wafer unit to form a chip wafer unit and the color conversion layer unit, so as to obtain the chip structure.

In some embodiments, a step of attaching the color conversion layer unit to a light-exit side of the initial chip wafer unit includes: forming a first indium zinc oxide layer on a side of the initial chip wafer unit away from the temporary substrate; forming a second indium zinc oxide layer on a side of the color conversion layer unit away from the initial first substrate; and bonding the first indium zinc oxide layer and the second indium zinc oxide layer to form an attaching layer connecting the initial chip wafer unit and the color conversion layer unit.

In some embodiments, the step of attaching the color conversion layer unit to a light-exit side of the initial chip wafer unit includes: forming a first initial metal sub-layer and a second initial metal sub-layer on a side of the initial chip wafer unit away from the temporary substrate, the second initial metal sub-layer is composed of a plurality of first-type metal protrusions formed on a side of the first initial metal sub-layer away from the temporary substrate; forming a third initial metal sub-layer on a side of the color conversion layer unit away from the initial first substrate; and bonding the first initial metal sub-layer, the second initial metal sub-layer, and the third initial metal sub-layer to form an attaching layer connecting the initial chip wafer unit and the color conversion layer unit.

In some embodiments, the step of attaching the color conversion layer unit to a light-exit side of the initial chip wafer unit includes: connecting the initial chip wafer unit and the color conversion layer unit by using an adhesive glue.

In some embodiments, a step of bonding the first indium zinc oxide layer and the second indium zinc oxide layer includes: treating a surface of the first indium zinc oxide layer away from the temporary substrate by adopting oxygen plasma; treating a surface of the second indium zinc oxide layer away from the initial first substrate by adopting oxygen plasma; and pressing the first indium zinc oxide layer and the second indium zinc oxide layer under a temperature condition of 150 °C to 240 °C, inclusive, so as to form the attaching layer.

In some embodiments, after the step of attaching the color conversion layer unit to a light-exit side of the initial chip wafer unit, the manufacturing method includes: removing the temporary substrate to form a chip wafer unit; and thinning the initial first substrate to form a first substrate, so as to obtain the chip structure.

In yet another aspect, a display substrate is provided. The display substrate includes the chip structure as described in any of the above embodiments.

In yet another aspect, a display device is provided. The display device includes the display substrate as described above.

### BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art may obtain other drawings according to these drawings. In addition, the accompanying drawings to be described below may be regarded as schematic diagrams, and are not limitations on an actual size of a product, an actual process of a method and actual timings of signals to which the embodiments of the present disclosure relate.
FIG. 1 is a structural diagram of a chip structure, in accordance with some embodiments of the present disclosure;
FIG. 2 is a structural diagram of another chip structure, in accordance with some embodiments of the present disclosure;
FIG. 3 is a structural diagram of yet another chip structure, in accordance with some embodiments of the present disclosure;
FIG. 4 is a structural diagram of a wafer, in accordance with some embodiments of the present disclosure;
FIG. 5 is a flow chart of a manufacturing method for an initial chip wafer unit, in accordance with some embodiments of the present disclosure;
FIG. 6 to FIG. 13 are diagrams showing steps of the manufacturing method for the initial chip wafer unit, in accordance with some embodiments of the present disclosure;
FIG. 14 is a flow chart of a manufacturing method for a color conversion layer unit, in accordance with some embodiments of the present disclosure;
FIG. 15A to FIG. 17 are diagrams showing steps of the manufacturing method for the color conversion layer unit, in accordance with some embodiments of the present disclosure;
FIG. 18 is a flow chart of forming a chip structure by assembling a color conversion layer unit and an initial chip wafer unit, in accordance with some embodiments of the present disclosure;
FIG. 19 to FIG. 26 are diagrams showing steps of forming the chip structure by assembling the color conversion layer unit and the initial chip wafer unit, in accordance with some embodiments of the present disclosure;
FIG. 27 is a flow chart of forming another chip structure by assembling a color conversion layer unit and an initial chip wafer unit, in accordance with some embodiments of the present disclosure;
FIG. 28 and FIG. 29 are diagrams showing steps of forming the another chip structure by assembling the color conversion layer unit and the initial chip wafer unit, in accordance with some embodiments of the present disclosure;
FIG. 30 is a flow chart of forming yet another chip structure by assembling a color conversion layer unit and an initial chip wafer unit, in accordance with some embodiments of the present disclosure;
FIG. 31A to FIG. 33 are diagrams showing steps of forming the yet another chip structure by assembling the color conversion layer unit and the initial chip wafer unit, in accordance with some embodiments of the present disclosure;
FIG. 34 is a top view of a chip structure, in accordance with some embodiments of the present disclosure;
FIG. 35 is a cross-sectional view of the chip structure taken along the cross-sectional line HH in the top view, in accordance with some embodiments of the present disclosure;
FIG. 36 is a structural diagram of a display substrate, in accordance with some embodiments of the present disclosure; and
FIG. 37 is a structural diagram of a display device, in accordance with some embodiments of the present disclosure.

### DETAILED DESCRIPTION

Technical solutions in some embodiments of the present disclosure will be described clearly and completely with reference to the accompanying drawings below. Obviously, the described embodiments are merely some but not all embodiments of the present disclosure. All other embodiments obtained by a person having ordinary skill in the art based on the embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed in an open and inclusive meaning, i.e., "including, but not limited to". In the description of the specification, the terms such as "one embodiment," "some embodiments," "exemplary embodiments," "example," "specific example" or "some examples" are intended to indicate that specific features, structures, materials or characteristics related to the embodiment(s) or example(s) are included in at least one embodiment or example of the present disclosure. Schematic representations of the above term do not necessarily refer to the same embodiment(s) or example(s). In addition, specific features, structures, materials or characteristics may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, the features defined with "first" and "second" may explicitly or implicitly include one or more of the features. In the description of the embodiments of the present disclosure, the term "a (the) plurality of/multiple" means two or more unless otherwise specified.

The phrase "at least one of A, B and C" has the same meaning as the phrase "at least one of A, B or C", both including following combinations of A, B and C: only A, only B, only C, a combination of A and B, a combination of A and C, a combination of B and C, and a combination of A, B and C.

"A and/or B" includes following three combinations: only A, only B, and a combination of A and B.

The term such as "parallel", "perpendicular" or "equal" as used herein includes a stated case and a case similar to the stated case within an acceptable range of deviation determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°. The term "equal" includes absolute equality and approximate equality, and an acceptable range of deviation of the approximate equality may be, for example, a difference between two equals of less than or equal to 5% of either of the two equals.

It will be understood that, when a layer or element is referred to as being on another layer or substrate, it may be that the layer or element is directly on the another layer or substrate, or that there is an intermediate layer between the layer or element and the another layer or substrate.

Exemplary embodiments are described herein with reference to segmental views and/or plan views as idealized exemplary drawings. In the accompanying drawings, thicknesses of layers and sizes of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Therefore, the regions shown in the accompanying drawings are schematic in nature, and their shapes are not intended to show actual shapes of regions in an apparatus, and are not intended to limit the scope of the exemplary embodiments.

The current red light Micro-LEDs (Micrometer-sized Light-emitting Diodes) are mostly made of AlGaInP (Aluminum Gallium Indium Phosphide, red light semiconductor) material, and their efficiency may reach more than 60% under a normal chip size. However, as the chip size is reduced to the micrometer scale, the efficiency will decrease to below 1%. In addition, in a process of mass transfer, disadvantages of the AlGaInP material are also quite obvious. Mass transfer requires materials to have good mechanical strength to avoid cracking during chip handling and placement. However, a poor mechanical performance of the AlGaInP material will increase the difficulty of mass transfer.

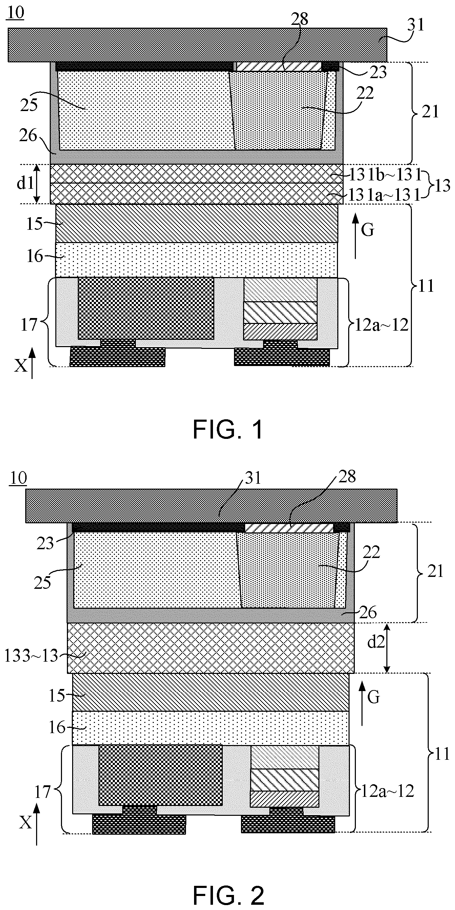

In light of this, the present disclosure provides a chip structure 10. As shown in FIG. 1 to FIG. 3, the chip structure 10 includes: a chip wafer unit 11 and a color conversion layer unit 21 arranged on a light-exit side G of the chip wafer unit 11; the chip wafer unit 11 includes: a plurality of sub-pixel light-emitting function layers 12; the color conversion layer unit 21 includes: color conversion layers 22 arranged on the light-exit side G of the chip wafer unit 11; the chip structure 10 further includes: an attaching layer 13, arranged between the chip wafer unit 11 and the color conversion layer unit 21 and configured to attach the chip wafer unit 11 and the color conversion layer unit 21.

In some examples, as shown in FIG. 1 to FIG. 3, a sub-pixel light-emitting function layer 12 of the plurality of sub-pixel light-emitting function layers 12 in the chip wafer unit 11 is configured to emit light of one of a plurality of colors, and multiple sub-pixel light-emitting function layers 12 may be configured to emit light of a same color. For example, light of the plurality of colors includes blue light. For example, a first sub-pixel light-emitting function layer 12a is configured to emit blue light. The color conversion layer unit 21 is arranged on the light-exit side G of the chip wafer unit 11, and on a light-exit side G of each sub-pixel light-emitting function layer 12, the sub-pixel light-emitting function layer 12 is provided with a corresponding color conversion layer 22 in the color conversion layer unit 21.

For example, the chip wafer unit 11 and the color conversion layer unit 21 are separately manufactured, and then the attaching layer 13 is attached to the chip wafer unit 11 and the color conversion layer unit 21 to form the chip structure 10. The transfer efficiency of Micro-LEDs may be improved, the thickness of the chip may be reduced, and the manufacture precision and the product yield may be improved. The attaching effect of the attaching layer 13 may be an adhesive bonding effect or a metal bonding effect. The specific content can be found in the following description, which will not be elaborated on here.

In some embodiments, as shown in FIG. 1 to FIG. 3, the attaching layer 13 is any one of an indium zinc oxide bonding layer 131, a metal bonding layer 132, and an adhesive glue layer 133.

In some examples, as shown in FIG. 1, the attaching layer 13 is an indium zinc oxide bonding layer 131; the indium zinc oxide bonding layer 131 includes a first indium zinc oxide layer 131a and a second indium zinc oxide layer 131b arranged in a stack along a first direction X, and the first indium zinc oxide layer 131a and the second indium zinc oxide layer 131b are connected through a bonding interaction of molecular bonds. The first indium zinc oxide layer 131a is stacked on and connected to the chip wafer unit 11, and the second indium zinc oxide layer 131b is stacked on and connected to the color conversion layer unit 21. The attaching between the chip wafer unit 11 and the color conversion layer unit 21 is achieved through the bonding interaction of molecular bonds between the first indium zinc oxide layer 131a and the second indium zinc oxide layer 131b, thereby forming the chip structure 10. The specific manufacturing method can be found in the following description, which will not be elaborated on here.

The first direction X is a direction from the chip wafer unit 11 to the color conversion layer unit 21. It can be understood that the first direction X is parallel to a light-exit direction of the chip wafer unit 11.

The first indium zinc oxide layer 131a is stacked on the chip wafer unit 11 by a photolithography process, and the second indium zinc oxide layer 131b is stacked on the color conversion layer unit 21 by a photolithography process, so dimensional deviations of the first indium zinc oxide layer 131a and the second indium zinc oxide layer 131b are relatively small, so that the accuracy of the formed indium zinc oxide layers is high, and the accuracy of the formed attaching layer 13 may be improved by using the indium zinc oxide bonding layer 131 as the attaching layer 13.

In some examples, as shown in FIG. 1, a dimension d1 of the indium zinc oxide bonding layer 131 in the first direction X is in a range of 100 nm to 300 nm, inclusive.

For example, the dimension d1 of the indium zinc oxide bonding layer 131 in the first direction X is 100 nm, 150 nm, 200 nm, or 250 nm, which is not limited here. It can be understood that the dimension d1 of the indium zinc oxide bonding layer 131 in the first direction X is a film thickness thereof. A thickness of less than 100 nm will result in an unstable bonding interaction of the indium zinc oxide bonding layer 131, while an excessively large thickness of the indium zinc oxide bonding layer 131 will increase the thickness of the chip structure 10. By arranging the indium zinc oxide bonding layer 131 with the thickness of 100 nm to 300 nm, the chip wafer unit 11 and the color conversion layer unit 21 may be well attached.

In some embodiments, as shown in FIG. 2, the attaching layer 13 is an adhesive glue layer 133. For example, a material of the adhesive glue layer 133 is an organic adhesive material such as epoxy resins. The attaching between the chip wafer unit 11 and the color conversion layer unit 21 is achieved through the adhesive effect of the adhesive glue layer 133, thereby forming the chip structure 10. The specific manufacturing method can be found in the following description, which will not be elaborated on here.

In some examples, as shown in FIG. 2, a dimension d2 of the adhesive glue layer 133 in the first direction X is in a range of 5 µm to 10 µm, inclusive.

For example, the dimension d2 of the adhesive glue layer 133 in the first direction X may be, for example, 5 µm, 6 µm, 7 µm, 8 µm, 9 µm, or 10 µm, which is not limited here.

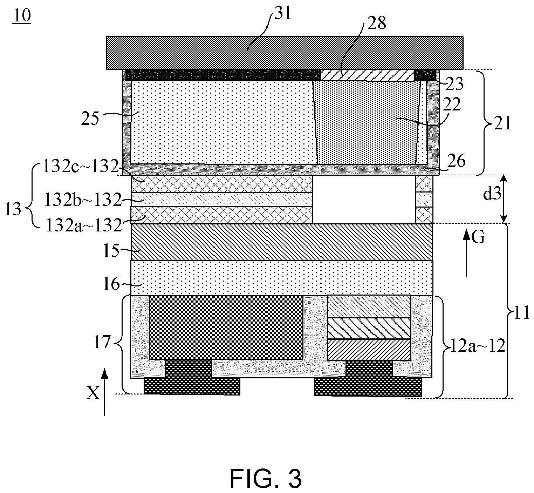

In some examples, as shown in FIG. 3, the attaching layer 13 is a metal bonding layer 132; the metal bonding layer 132 includes: a first metal sub-layer 132a, a second metal sub-layer 132b, and a third metal sub-layer 132c that are arranged in a stack along the first direction X, where the second metal sub-layer 132b is a eutectic alloy layer connecting the first metal sub-layer 132a and the third metal sub-layer 132c.

The first metal sub-layer 132a is stacked on and connected to the chip wafer unit 11, and the third metal sub-layer 132c is stacked on and connected to the color conversion layer unit 21, so the first metal sub-layer 132a and the third metal sub-layer 132c are connected to each other through the eutectic alloy layer (the second metal sub-layer 132b), so that the chip wafer unit 11 and the color conversion layer unit 21 are bonded to each other to form the chip structure 10. The specific manufacturing method can be found in the following description, which will not be elaborated on here.

In some examples, as shown in FIG. 3, a dimension d3 of the metal bonding layer 132 in the first direction X is in a range of 6 µm to 12 µm, inclusive.

For example, the dimension d3 of the metal bonding layer 132 in the first direction X is 6 µm, 8 µm, 9 µm, 10 µm, 11 µm, or 12 µm, which is not limited here.

In some examples, a manufacturing method for a chip structure 10 includes: forming an initial chip wafer unit 110 and a color conversion layer unit 21, then forming an attaching layer 13, attaching the initial chip wafer unit 110 and the color conversion layer unit 21 to obtain a chip wafer unit 11, and forming the chip structure 10. To illustrate the technical solution more clearly, three embodiments are provided below to describe the manufacturing method for the chip structure 10.

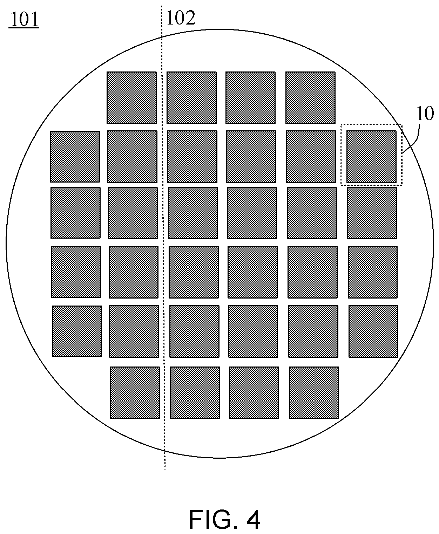

It will be understood that for clarity, the manufacturing method for the chip structure 10 is described below by taking a single chip structure 10 as an example. It can be understood that the manufacturing method for the chip structure 10 is a method in which a wafer 101 including a plurality of chip structures 10 arranged in an array is formed first, and then a single chip structure 10 is formed by cutting the wafer 101. A structure of the wafer 101 is as shown in FIG. 4.

A first embodiment (Embodiment 1) of a manufacturing method for a chip structure 10 is described below, according to which the chip structure 10 as shown in FIG. 1 is formed. In steps of manufacturing the chip structure 10, examples of a composition of the chip structure 10 can be understood by reference to FIG. 1 and the content as shown in the step diagram.

### Embodiment 1

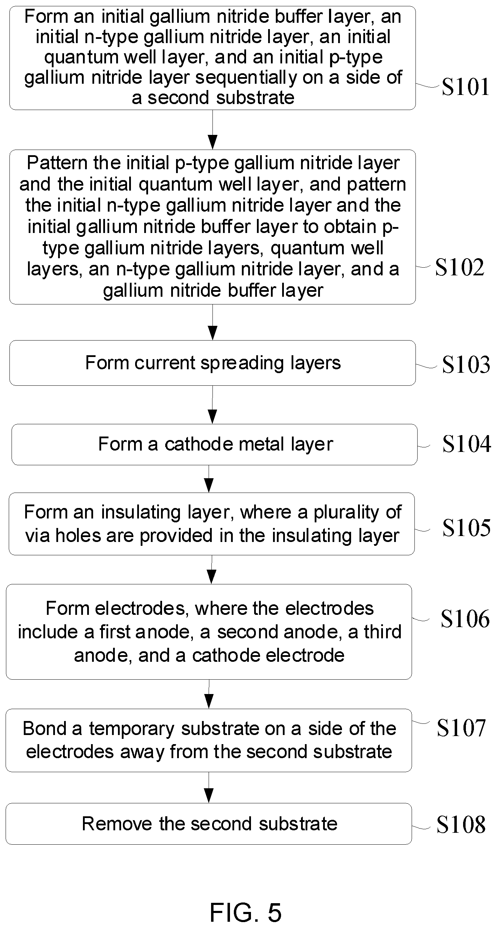

Specifically, as shown in FIG. 5, the steps of manufacturing the initial chip wafer unit 110 include steps S101 to S108.

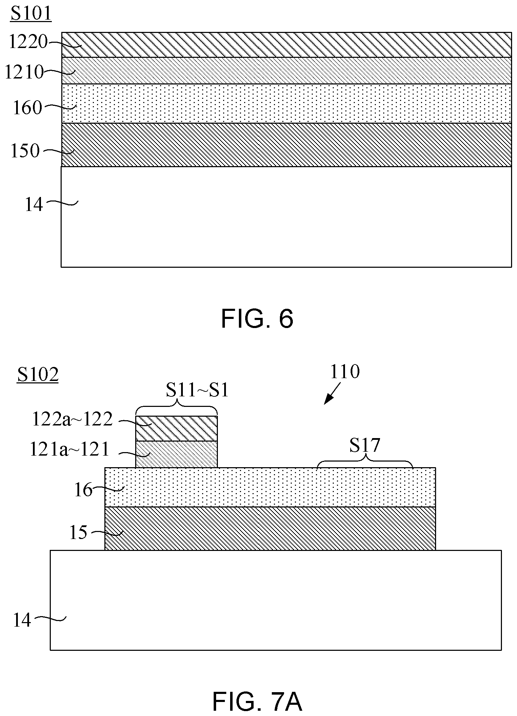

In S101, as shown in FIG. 6, an initial gallium nitride buffer layer 150, an initial n-type gallium nitride layer 160, an initial quantum well layer 1210, and an initial p-type gallium nitride layer 1220 are sequentially formed on a side of a second substrate 14.

For example, the second substrate 14 may be any one of a sapphire substrate and a silicon-based substrate.

For example, the initial quantum well layer 1210 may be a blue quantum well layer, and sub-pixel light-emitting function layers 12 (not shown in FIG. 6, and may be referenced to FIG. 1) formed by the blue quantum well layer emits blue light.

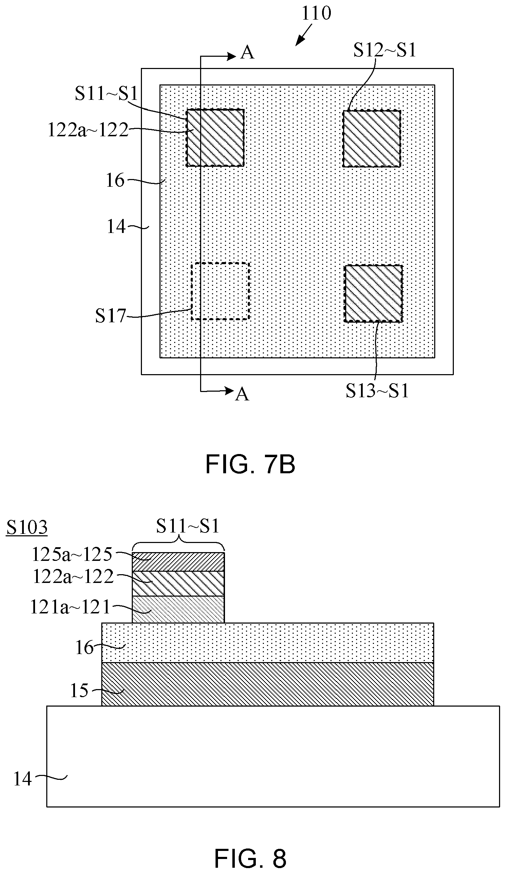

In S102, as shown in FIG. 7A and FIG. 7B, the initial p-type gallium nitride layer 1220 and the initial quantum well layer 1210 are patterned, and the initial n-type gallium nitride layer 160 and the initial gallium nitride buffer layer 150 are patterned to obtain p-type gallium nitride layers 122, quantum well layers 121, an n-type gallium nitride layer 16, and a gallium nitride buffer layer 15.

For example, the initial quantum well layer 1210 and the initial p-type gallium nitride layer 1220 are patterned by a photolithography process, and the initial quantum well layer 1210 and the initial p-type gallium nitride layer 1220 in regions each between adjacent sub-pixel light-emitting function layers 12 and a negative electrode region S17 are removed.

For example, as shown in FIG. 7A and FIG. 7B, the initial chip wafer unit 110 has three sub-pixel regions S1 and one negative electrode region S17, where the three sub-pixel regions S1 are a first sub-pixel region S11, a second sub-pixel region S12, and a third sub-pixel region S13, respectively. The initial quantum well layer 1210 and the initial p-type gallium nitride layer 1220 are patterned by a photolithography process to remove the initial quantum well layer 1210 and the initial p-type gallium nitride layer 1220 outside the three sub-pixel regions S1 and the negative electrode region S17. It can be understood that the three sub-pixel regions S1 are light-emitting regions of the chip structure 10. That is, the sub-pixel regions S1 and the negative electrode region S17 of the initial chip wafer unit 110 are also sub-pixel regions S1 and a negative electrode region S17 of the chip structure 10.

The plurality of sub-pixel light-emitting function layers 12 of the chip wafer unit 11 include a first sub-pixel light-emitting function layer 12a, a second sub-pixel light-emitting function layer 12b, and a third sub-pixel light-emitting function layer 12c. The first sub-pixel light-emitting function layer 12a is located in the first sub-pixel region S11, the second sub-pixel light-emitting function layer 12b is located in the second sub-pixel region S12, and the third sub-pixel light-emitting function layer 12c is located in the third sub-pixel region S13. The negative electrode region S17 is used to hold a common cathode layer 17. The specific description of the common cathode layer 17 can be found in the following description, which will not be elaborated on here.

As shown in FIG. 7A and FIG. 7B, in this step, a first quantum well layer 121a and a first p-type gallium nitride layer 122a in the first sub-pixel light-emitting function layer 12a, a second quantum well layer and a second p-type gallium nitride layer in the second sub-pixel light-emitting function layer 12b, and a third quantum well layer and a third p-type gallium nitride layer in the third sub-pixel light-emitting function layer 12c are formed. FIG. 7A is a cross-sectional view taken along the section line AA in FIG. 7B.

For example, the initial n-type gallium nitride layer 160 and the initial gallium nitride buffer layer 150 are patterned by a photolithography process to form the n-type gallium nitride layer 16 and the gallium nitride buffer layer 15; the n-type gallium nitride layer 16 is a conductive layer connecting the common cathode layer 17 and each of the first sub-pixel light-emitting function layer 12a, the second sub-pixel light-emitting function layer 12b, the third sub-pixel light-emitting function layer 12c.

In S103, as shown in FIG. 8, current spreading layers 125 are formed.

For example, an initial current spreading layer is formed first, and the current spreading layers 125 are formed by patterning the initial current spreading layer through a photolithography process. The current spreading layers 125 include a first current spreading layer 125a located in the first sub-pixel region S11, a second current spreading layer located in the second sub-pixel region S12 (not shown in FIG. 8, and may be referenced to FIG. 7B), and a third current spreading layer located in the third sub-pixel region S13 (not shown in FIG. 8, and may be referenced to FIG. 7B).

The current spreading layers 125 are made of ITO (Indium Tin Oxide), and the current spreading layers 125 are arranged in the sub-pixel regions S1, so as to facilitate hole transmission and improve the electrical properties of the chip structure 10.

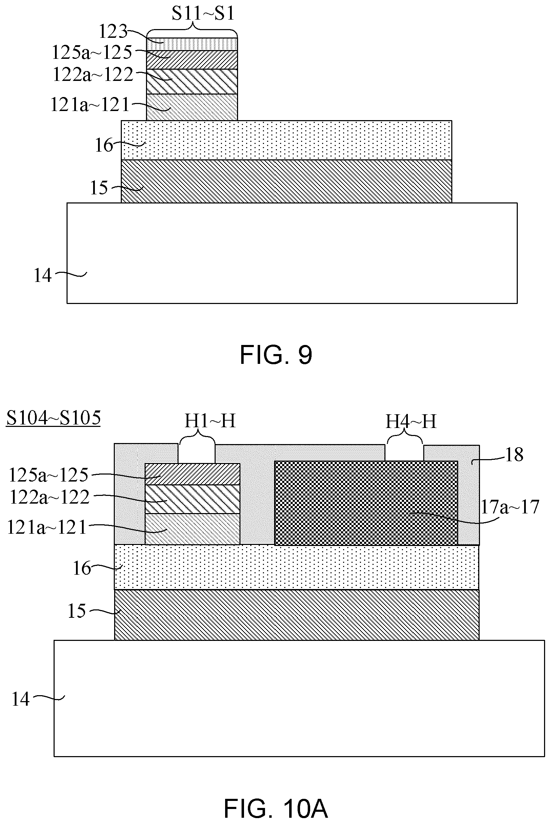

In some examples, as shown in FIG. 9, the manufacturing method for the initial chip wafer unit 110 further includes a step of forming reflective metal layers 123.

For example, an initial reflective metal layer is formed on a side of the current spreading layers 125 away from the second substrate 14, and a reflective metal layer 123 in each sub-pixel light-emitting function layer 12 is formed by patterning the initial reflective metal layer through a photolithography process. The reflective metal layer 123 has a function of reflecting light, and can improve a light extraction rate of the sub-pixel light-emitting function layer 12.

It will be noted that in the following exemplary drawings, the reflective metal layer 123 is not shown.

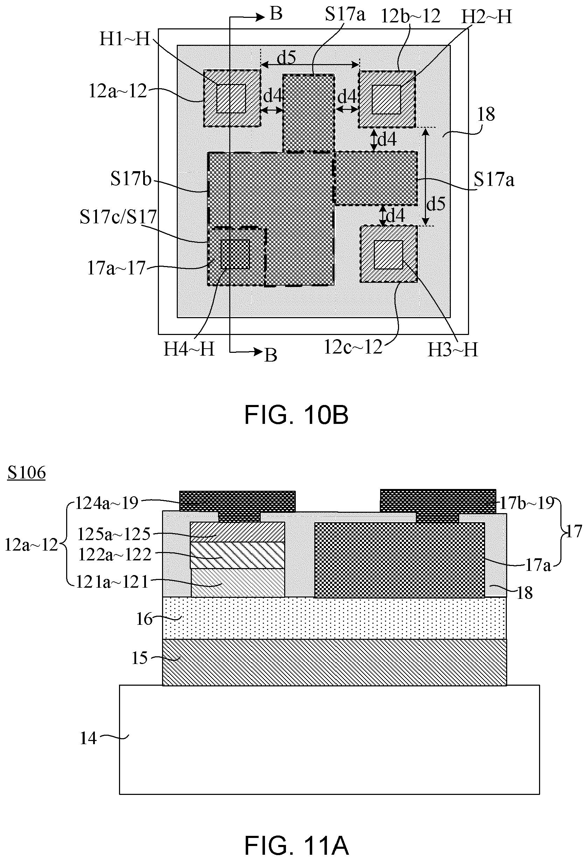

In S104, as shown in FIG. 10A and 10B, a cathode metal layer 17a is formed. FIG. 10A is a cross-sectional view taken along the section line BB in FIG. 10B.

For example, the cathode metal layer 17a is formed by a photolithography process.

For example, a material of the cathode metal layer 17a may be any one of titanium, aluminum, nickel, and gold.

For example, as shown in FIG. 10B, the cathode metal layer 17a includes a first portion S17c covering the negative electrode region S17, and a second portion S17b located in the common cathode layer 17 and between adjacent sub-pixel light-emitting function layers 12.

As shown in FIG. 10B, the cathode metal layer 17a further includes portions each located between two adjacent sub-pixel light-emitting function layers 12. The cathode metal layer 17a has a function of connecting the n-type gallium nitride layer 16 and a raised cathode electrode 17b (not shown in FIG. 10B, and may be referenced to FIG. 11A). A portion of the cathode metal layer 17a located between two adjacent sub-pixel light-emitting function layers 12 is referred to as a support metal layer S17a. By arranging the second portion S17b of the cathode metal layer 17a in the common cathode layer 17 and between the adjacent sub-pixel light-emitting function layers 12, and arranging the support metal layer S17a between the sub-pixel light-emitting function layers 12, the chip structure 10 may be reinforced, and the chip structure 10 may be prevented from cracking. Moreover, a volume of the cathode metal layer 17a is increased, so that a resistance of the chip structure 10 may be reduced.

In some examples, as shown in FIG. 10B, a portion of the cathode metal layer 17a located between two adjacent sub-pixel light-emitting function layers 12 and the two adjacent sub-pixel light-emitting function layers 12 have a distance d4 therebetween. The distance d4 between the sub-pixel light-emitting function layers 12 and the cathode metal layer 17a is in a range of one tenth (1/10) to one third (1/3) of a distance d5 between the two adjacent sub-pixel light-emitting function layers 12, inclusive.

For example, the distance d4 between the sub-pixel light-emitting function layers 12 and the cathode metal layer 17a is one tenth (1/10), one fourth (1/4), or one third (1/3) of the distance d5 between the two adjacent sub-pixel light-emitting function layers 12 which is not limited here.

By arranging the support metal layer S17a between two adjacent sub-pixel light-emitting function layers 12, and setting the distance d4 between the sub-pixel light-emitting function layers 12 and the cathode metal layer 17a in the range of 1/10 to 1/3 of the distance d5 between the two adjacent sub-pixel light-emitting function layers 12, an area of the cathode metal layer 17a can be increased under the condition of ensuring an aperture ratio of a region where each sub-pixel light-emitting function layer 12 of the chip structure 10 is located, so that the resistance of the chip structure 10 is reduced, the chip structure 10 is prevented from cracking, and the stability of the chip structure 10 is improved.

For example, as shown in FIG. 10B, the distance d4 between the sub-pixel light-emitting function layers 12 and the cathode metal layer 17a is in a range of 8 µm to 10 µm, inclusive.

For example, the distance d4 between the sub-pixel light-emitting function layers 12 and the cathode metal layer 17a is 8 µm, 9 µm or 10 µm, which is not limited here.

In S105, as shown in FIG. 10A and FIG. 10B, an insulating layer 18 is formed, and a plurality of via holes H are provided in the insulating layer 18.

For example, an initial insulating layer is formed on a side of the cathode metal layer 17a away from the second substrate 14 by a deposition process, and a plurality of via holes H are formed therein by a photolithography process. As shown in FIG. 10B, the plurality of via holes H include a first via hole H1, a second via hole H2, a third via hole H3, and a fourth via hole H4. The first via hole H1 is arranged to correspond to the first sub-pixel light-emitting function layer 12a, the second via hole H2 is arranged to correspond to the second sub-pixel light-emitting function layer 12b, the third via hole H3 is arranged to correspond to the third sub-pixel light-emitting function layer 12c, and the fourth via hole H4 is arranged to correspond to the negative electrode region S17.

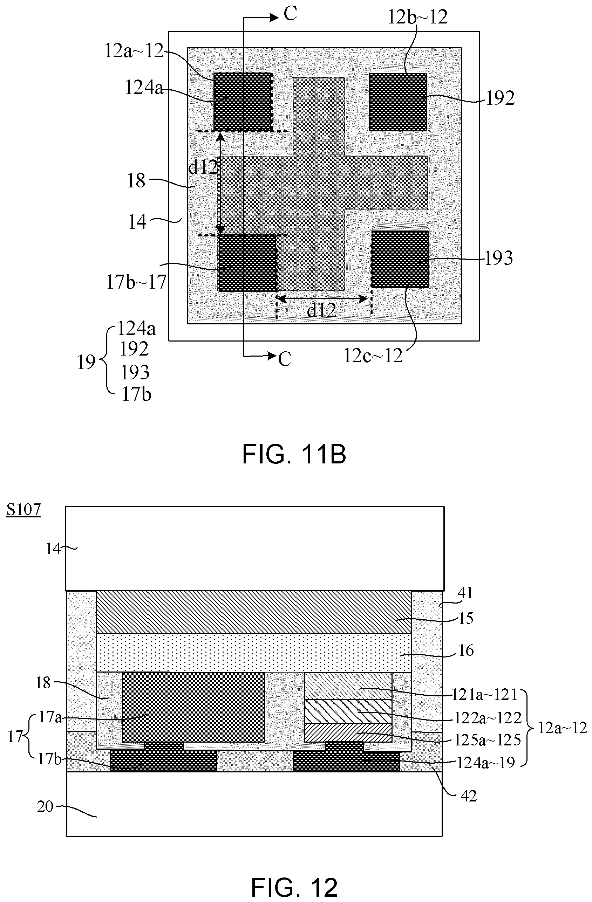

In S106, as shown in FIG. 11A and FIG. 11B, electrodes 19 are formed, which include a first anode 124a, a second anode 192, a third anode 193, and a cathode electrode 17b. FIG. 11A is a cross-sectional view taken along the section line CC in FIG. 11B.

Among them, the first anode 124a, the second anode 192, and the third anode 193 are referred to as anode electrodes.

For example, the electrodes 19 are formed by a patterning process. The first anode 124a is arranged to correspond to the first sub-pixel light-emitting function layer 12a, the second anode 192 is arranged to correspond to the second sub-pixel light-emitting function layer 12b, and the third anode 193 is arranged to correspond to the third sub-pixel light-emitting function layer 12c; and the cathode electrode 17b and the cathode metal 17a form the common cathode layer 17.

In S107, as shown in FIG. 12, a temporary substrate 20 is bonded on a side of the electrodes 19 away from the second substrate 14.

For example, the temporary substrate 20 is temporarily bonded to a temporary adhesive layer 41 and a deadhesive layer 42, the temporary adhesive layer 41 has an adhesive effect, and the deadhesive layer 42 may be deactivated under an irradiation of ultraviolet light. The temporary adhesive layer 41 and the deadhesive layer 42 have a role of temporarily bonding the temporary substrate 20.

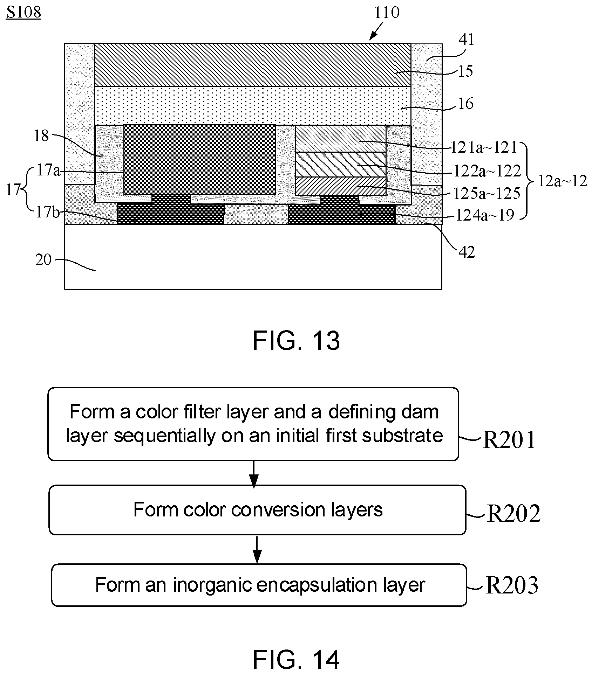

In S108, as shown in FIG. 13, the second substrate 14 is removed.

The initial chip wafer unit 110 is formed after removing the second substrate 14.

For example, the second substrate 14 may be a sapphire substrate, and accordingly, the sapphire substrate is peeled off by a laser.

For example, the second substrate 14 may be a silicon-based substrate, and accordingly, the temporary substrate 20 is protected by an acid-resistant film or wax seal, the initial chip wafer unit 110 is placed in an etching sink containing hydrofluoric acid (HF), and the second substrate 14 is removed by etching.

It can be understood that in comparison to the chip wafer unit 11, the initial chip wafer unit 110 is provided therein with the temporary substrate 20 on a side of the electrodes 19 away from the gallium nitride buffer layer 15. The temporary substrate 20, the adhesive layer 41 and the deadhesive layer 42 in the initial chip wafer unit 110 are removed, and the chip wafer unit 11 is obtained.

Steps of manufacturing the color conversion layer unit 21 are described in the following, and as shown in FIG. 14, the steps include steps R201 to R203.

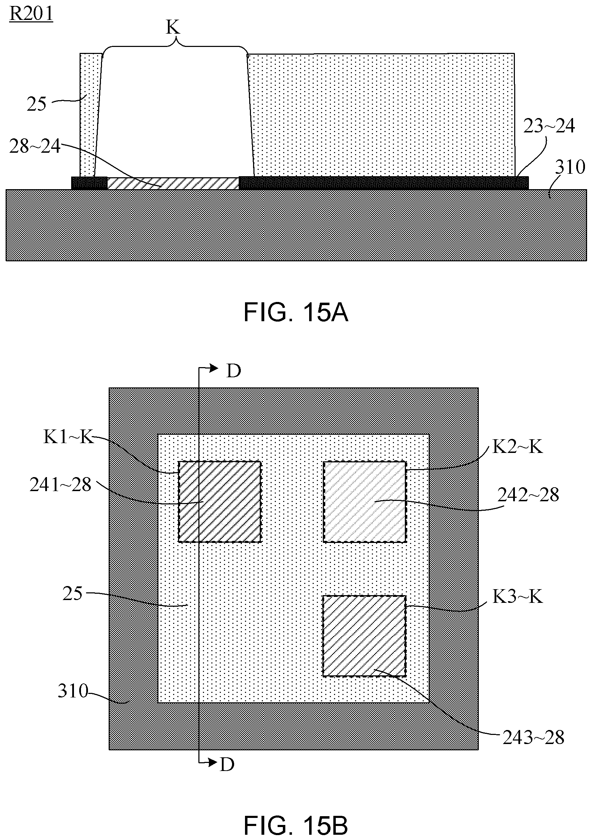

In R201, as shown in FIG. 15A, a color filter layer 24 and a defining dam layer 25 are sequentially formed on an initial first substrate 310.

The color filter layer 24 includes a black matrix layer 23 and a plurality of light-filtering film layers 28 defined by the black matrix layer 23; and the defining dam layer 25 is arranged on a side of the color filter layer 24 away from the initial first substrate 310.

For example, the initial first substrate 310 may be a glass substrate.

For example, the black matrix layer 23 and the plurality of light-filtering film layers 28 defined by the black matrix layer 23 are formed by coating, exposing, developing, post-baking, and the like. As shown in FIG. 15B, the plurality of light-filtering film layers 28 include a first light-filtering film 241, a second light-filtering film 242 and a third light-filtering film 243. For example, the first light-filtering film 241 is a red light-filtering film, the second light-filtering film 242 is a green light-filtering film, and the third light-filtering film 243 is a blue light-filtering film. FIG. 15A is a cross-sectional view taken along the section line DD in FIG. 15B.

For example, as shown in FIG. 15A, the defining dam layer 25 is formed on a side of the black matrix layer 23 away from the initial first substrate 310 by coating, exposing, developing, post-baking, and the like, and a plurality of opening zones K are defined in the defining dam layer 25. For example, as shown in FIG. 15B, the plurality of opening zones K include a first opening zone K1, a second opening zone K2 and a third opening zone K3.

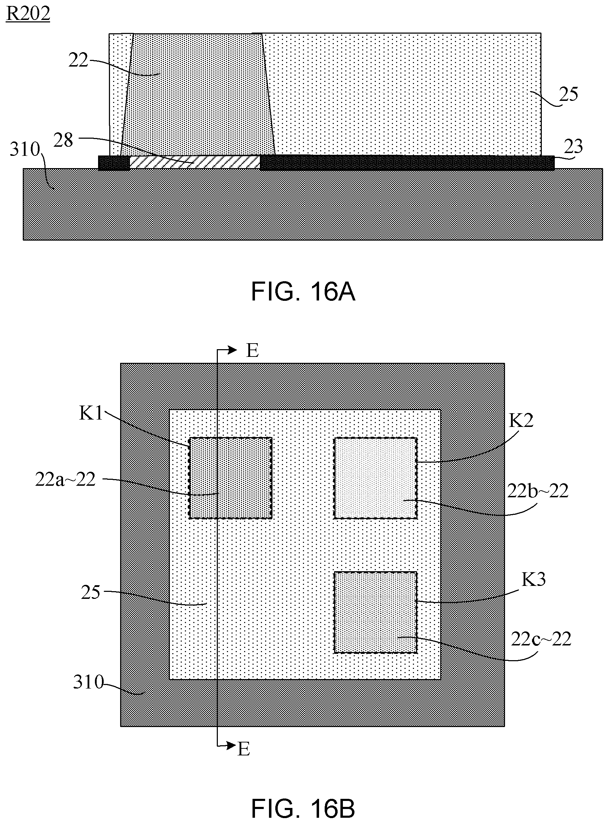

In R202, as shown in FIG. 16A, color conversion layers 22 are formed.

For example, as shown in FIG. 16B, color conversion layers 22 are formed in the first opening zone K1, the second opening zone K2, and the third opening zone K3 by coating, exposing, developing, and post-baking, or by ink-jet printing. For example, the color conversion layers 22 include a first quantum dot conversion part 22a, a scattering particle part 22b, and a third quantum dot conversion part 22c. The first quantum dot conversion part 22a is formed in the first opening zone K1, and the first quantum dot conversion part 22a is made of a red quantum dot light-emitting material; the scattering particle part 22b is formed in the second opening zone K2, and the scattering particle part 22b is made of scattering particles; the third quantum dot conversion part 22c is formed in the third opening zone K3, and the third quantum dot conversion part 22c is made of a green quantum dot light-emitting material. FIG. 16A is a cross-sectional view taken along the section line EE in FIG. 16B.

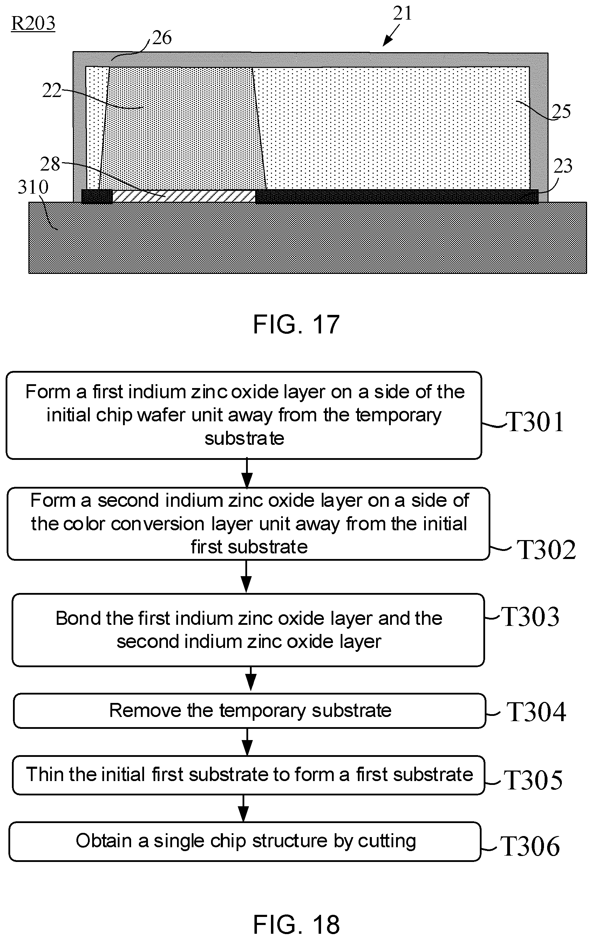

In R203, as shown in FIG. 17, an inorganic encapsulation layer 26 is formed.

After the inorganic encapsulation layer 26 is formed, the color conversion layer unit 21 is obtained.

For example, the inorganic encapsulation layer 26 is deposited by CVD (Chemical Vapor Deposition) on a side of the color conversion layer 22 away from the initial first substrate 310, and the inorganic encapsulation layer 26 covers the color conversion layers 22 and the defining dam layer 25.

Steps of forming the attaching layer 13, and steps of forming the chip structure 10 by assembling the color conversion layer unit 21 and the initial chip wafer unit 110 through the attaching layer 13 are described in the following. As shown in FIG. 18, the above steps include steps T301 to T306.

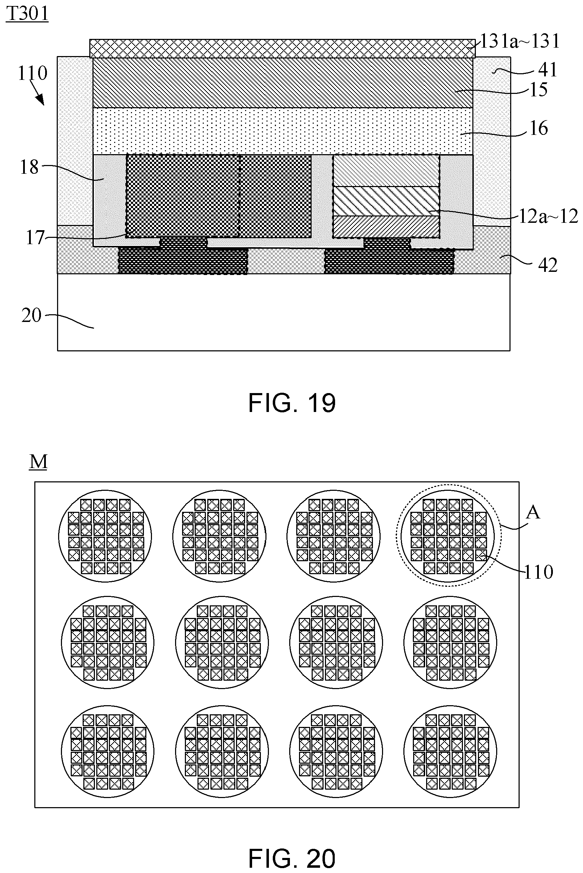

In T301, as shown in FIG. 19, a first indium zinc oxide layer 131a is formed on a side of the initial chip wafer unit 110 away from the temporary substrate 20.

That is, the first indium zinc oxide layer 131a is formed on a side of the gallium nitride buffer layer 15 away from the temporary substrate 20.

For example, the first indium zinc oxide layer 131a is formed by a photolithography process.

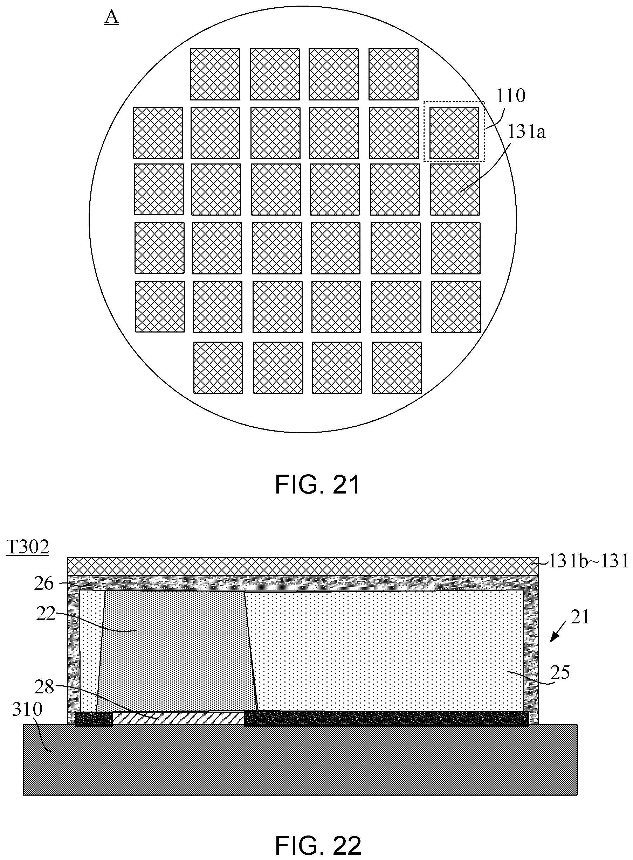

It can be understood that during a process of manufacturing the initial chip wafer unit 110, a first large plate M including a plurality of initial chip wafer units 110 arranged in an array and formed simultaneously is provided. As shown in FIG. 20. In this step, first indium zinc oxide layers are formed on the initial chip wafer units 110 of the first large plate M; and then, the first large plate M is cut, for example, by a special-shaped cutting, to form a plurality of first initial wafer sheets A. As shown in FIG. 21, a first initial wafer sheet A has a circular shape, and the first initial wafer sheet A includes a plurality of initial chip wafer units 110 each is provided thereon with a first indium zinc oxide layer 131a. For example, the first wafer sheet A has a size of 4 inches or 6 inches.

In T302, as shown in FIG. 22, a second indium zinc oxide layer 131b is formed on a side of the color conversion layer unit 21 away from the initial first substrate 310.

That is, the second indium zinc oxide layer 131b is formed on a side of the inorganic encapsulation layer 26 away from the initial first substrate 310.

For example, the second indium zinc oxide layer 131b is formed by a photolithography process.

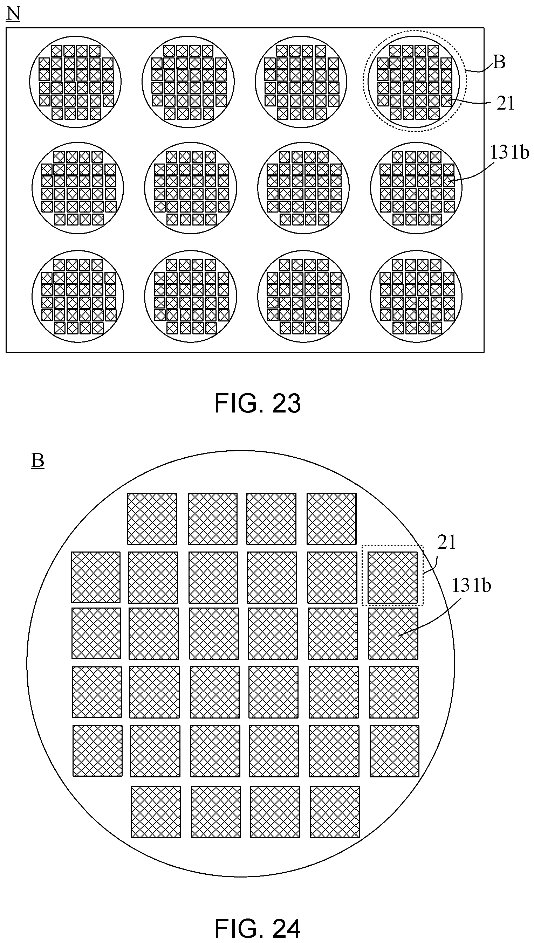

In the process of manufacturing the color conversion layer unit 21, a second large plate N including a plurality of color conversion layer units 21 arranged in an array and formed simultaneously is provided. As shown in FIG. 23, in this step, second indium zinc oxide layers 131b are formed on the color conversion layer units 21 of the second large panel N; and then, the second large plate N is cut, for example, by a special-shaped cutting, to form a plurality of second wafer sheets B. As shown in FIG. 24, a second initial wafer sheet B has a circular shape, and the second initial wafer sheet B includes a plurality of color conversion layer units 21 each is provided thereon with a second indium zinc oxide layer 131b. The second initial wafer sheet B has a same size as the first initial wafer sheet A.

Steps of assembling the first initial wafer sheet A and the second initial wafer sheet B to finally form a single chip structure 10 are described in the following. It will be noted that the following description is given as an example of a formation of a single chip structure 10.

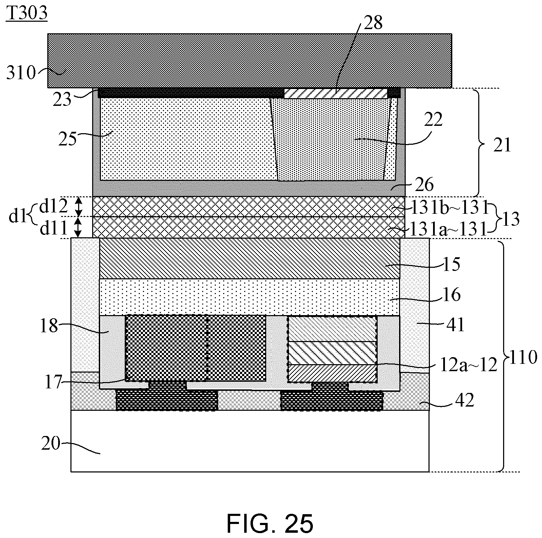

In T303, as shown in FIG. 25, the first indium zinc oxide layer 131a and the second indium zinc oxide layer 131b are bonded.

A bonding of the initial chip wafer unit 110 and the color conversion layer unit 21 is achieved by the bonding of the first indium zinc oxide layer 131a and the second indium zinc oxide layer 131b.

For example, a thickness d11 of the first indium zinc oxide layer 131a and a thickness d12 of the second indium zinc oxide layer 131b may be the same or different, which are not limited here. The sum of the thickness d11 of the first indium zinc oxide layer 131a and the thickness d12 of the second indium zinc oxide layer 131b is a film thickness of the indium zinc oxide bonding layer 131.

For example, the step of bonding the first indium zinc oxide layer 131a and the second indium zinc oxide layer 131b includes steps U1 to U3.

In U1, a surface of the first indium zinc oxide layer 131a away from the temporary substrate 20 is treated with oxygen plasma to activate the surface of the first indium zinc oxide layer 131a.

In U2, a surface of the second indium zinc oxide layer 131b away from the initial first substrate 310 is treated with oxygen plasma to activate the surface of the second indium zinc oxide layer 131b.

In U3, the first indium zinc oxide layer 131a and the second indium zinc oxide layer 131b are pressed together under a temperature condition of 150 °C to 240 °C, inclusive, so as to form the attaching layer.

For example, the two layers are heated to 150 °C first, then a pressure of 15,000 Newtons (N) is applied to them; next, the two layers are heated to 200 °C at a rate of 10 degrees centigrade/minute (°C/min); and then this temperature is maintained for 30 min to form the attaching layer 13.

In T304, the temporary substrate 20 is removed.

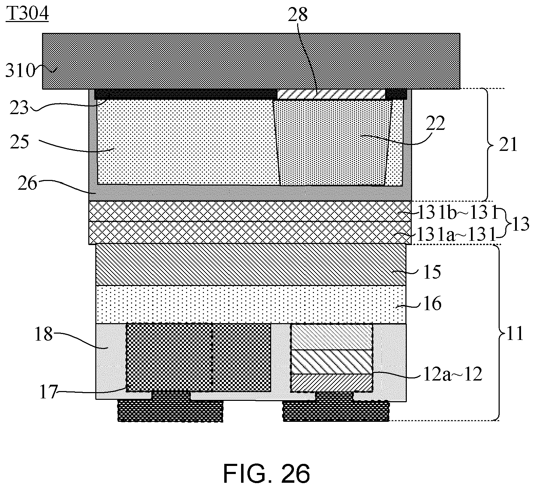

After the temporary substrate 20 is removed, the initial chip wafer unit 110 turns into a chip wafer unit 11, a structure of which is shown in FIG. 26.

For example, the deadhesive layer 42 is deactivated under an irradiation of ultraviolet light to remove the temporary adhesive layer 41, the deadhesive layer 42, and the temporary substrate 20

In T305, the initial first substrate 310 is thinned to form the first substrate 31.

After this step, an integral structure including a plurality of chip structures 10 each as shown in FIG. 1 is obtained.

For example, the initial first substrate 310 is thinned to a thickness of 60 µm to 200 µm, inclusive. A shape of the chip structure 10 formed in this way is close to a cube, so that the chip structure 10 is placed more stably and is beneficial to the use during subsequent processes. The usage of a thick initial first substrate 310 during manufacturing the chip structure 10 facilitates processing of the chip structure 10.

For example, an acid-resistant film is attached to a first surface of the initial first substrate 310 to protect layers thereon, and then the initial first substrate 310 is thinned at a second surface, where the plurality of sub-pixel light-emitting function layers 12 are arranged on the first surface of the initial first substrate 310.

In T306, the integral structure is cut to obtain a single chip structure 10.

For example, a blue film is attached to a surface of the first substrate 31 away from the electrodes 19 to protect layers on the first substrate 31, and then the integral structure is cut by laser to obtain the single chip structure 10.

The chip structure 10 shown in FIG. 1 is formed through the steps S101 to S108, the steps R201 to R203, and the steps T301 to T306. An orthographic projection of the indium zinc oxide bonding layer 131 on the plurality of sub-pixel light-emitting function layers 12 covers the plurality of sub-pixel light-emitting function layers 12. That is to say, in a case that the indium zinc oxide bonding layer 131 serves as the attaching layer 13, the indium zinc oxide bonding layer 131 is provided as a whole layer, and an orthographic projection of the indium zinc oxide bonding layer 131 on the first substrate 31 completely covers orthographic projections of the plurality of sub-pixel light-emitting function layers 12 on the first substrate 31. The indium zinc oxide bonding layer 131 is a transparent film layer, and thus the indium zinc oxide bonding layer 131 provided as a whole layer does not affect light emitted from the plurality of sub-pixel light-emitting function layers 12. In these embodiments, the indium zinc oxide bonding layer 131 serves as the attaching layer 13, so that the precision of the formed attaching layer 13 may be improved, the product yield of the chip structure 10 may be improved, and the thickness of the formed chip structure 10 is relatively small.

A second embodiment (Embodiment 2) of a manufacturing method for a chip structure 10 is described below, according to which the chip structure 10 as shown in FIG. 2 is formed. In steps of manufacturing the chip structure 10, examples of a composition of the chip structure 10 can be understood by reference to FIG. 2 and the content as shown in the step diagram.

### Embodiment 2

For example, the steps of manufacturing the initial chip wafer unit 110 can be made by reference to steps S101 to S108, and the steps of manufacturing the color conversion layer unit 21 can be made by reference to steps R201 to R203, which are not repeated here.

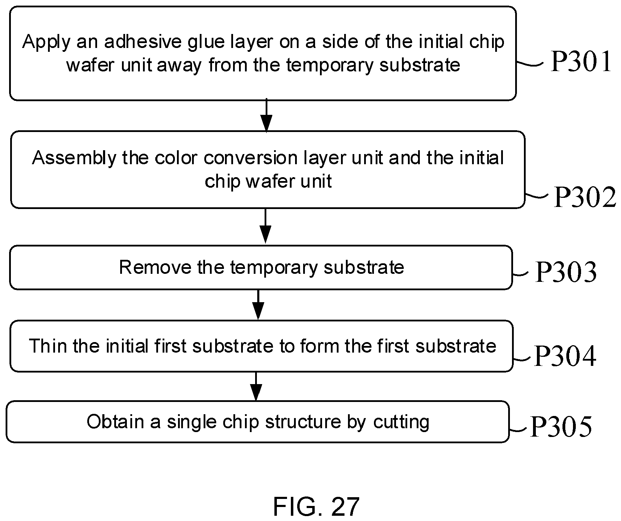

After the initial chip wafer unit 110 and the color conversion layer unit 21 are formed, the chip structure 10 is formed by assembling the color conversion layer unit 21 and the initial chip wafer unit 110 through the adhesive glue layer 133 serving as the attaching layer 13. As shown in FIG. 27, steps include steps P301 to P305.

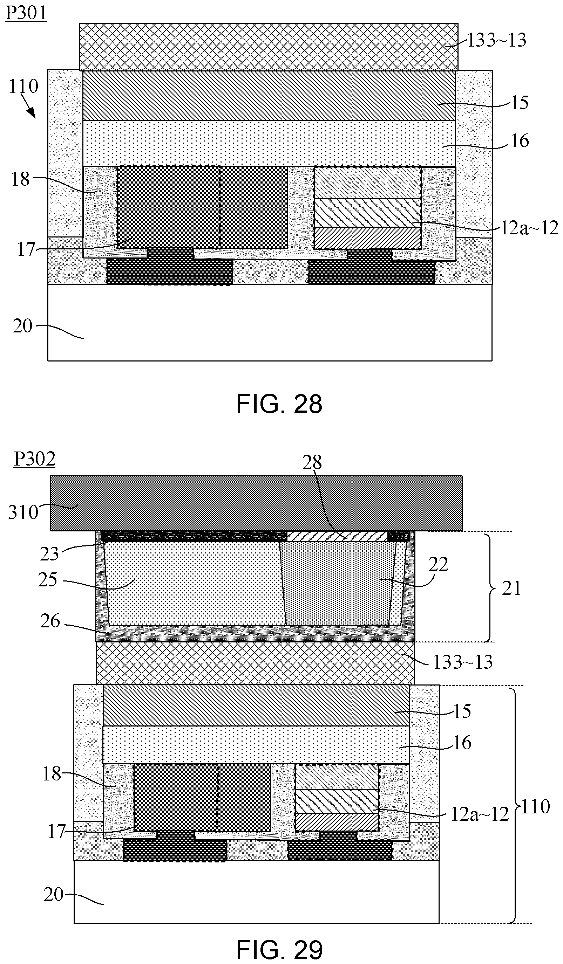

In P301, as shown in FIG. 28, the adhesive glue layer 133 is applied on a side of the initial chip wafer unit 110 away from the temporary substrate 20.

That is, a surface of the gallium nitride buffer layer 15 away from the temporary substrate 20 is coated with the adhesive glue layer 133.

For example, a material of the adhesive glue layer 133 is an organic adhesive material such as epoxy resins. The adhesive glue layer 133 is formed by a steel mesh printing process, and it is ensured that there is no residual material for forming the adhesive glue layer 133 in cutting channels 102. As shown in FIG. 4, a cutting channel 102 is located between two adjacent chip structures 10 in the wafer 101. Only one cutting channel 102 is shown in FIG. 4, and it can be understood that in order to obtain a single chip structure 10, a region between every two adjacent chip structures 10 is a cutting channel 102.

It can be understood that during a process of manufacturing the initial chip wafer unit 110, a large plate including a plurality of initial chip wafer units 110 arranged in an array and formed simultaneously is provided. In a process of manufacturing the color conversion layer unit 21, a large plate including a plurality of color conversion layer units 21 arranged in an array and formed simultaneously is provided. Before the color conversion layer unit 21 and the initial chip wafer unit 110 are assembled to form a cell, there is further a step of cutting the large plate having the initial chip wafer units 110 and the large plate having the color conversion layer units 21.

The large plate having the initial chip wafer units 110 is cut to form a plurality of third initial wafer sheets C, and each third initial wafer sheet C includes a plurality of initial chip wafer units 110 each provided with an adhesive glue layer 133. The large plate having the color conversion layer units 21 is cut to form a plurality of fourth initial wafer sheets D, and the fourth initial wafer sheet D includes a plurality of color conversion layer units 21.

For structures of the third initial wafer sheet C and the fourth initial wafer sheet D, reference may be made to examples of the first initial wafer sheet A and the second initial wafer sheet B shown in FIG. 21 and FIG. 24, which are not repeated here. In contrast, the third initial wafer sheet C includes the plurality of initial chip wafer units 110 each provided with an adhesive glue layer 133, while the first initial wafer sheet A includes the plurality of initial chip wafer units 110 each provided with a first indium zinc oxide layer 131a; and the fourth initial wafer sheet D includes the plurality of color conversion layer units 21, while the second initial wafer sheet B includes the plurality of color conversion layer units 21 each provided with a second indium zinc oxide layer 131b.

Steps of assembling the third initial wafer sheet C and the fourth initial wafer sheet D to finally form a single chip structure 10 are described in the following.

In P302, as shown in FIG. 29, the color conversion layer unit 21 and the initial chip wafer unit 110 are assembled.

The color conversion layer unit 21 and the initial chip wafer unit 110 are bonded by the adhesive glue layer 133.

In P303, the temporary substrate 20 is removed.

Specific steps can be made by reference to step T304, which is not repeated here.

In P304, the initial first substrate 310 is thinned to form the first substrate 31.

Specific steps can be made by reference to step T305, which is not repeated here.

In P305: a single chip structure 10 is obtained by cutting.

Specific steps can be made by reference to step T306, which is not repeated here.

The chip structure 10 shown in FIG. 2 is formed through the steps S101 to S108, the steps R201 to R203, and the steps P301 to P305. The attaching layer 13 is the adhesive glue layer 133, and an orthographic projection of the adhesive glue layer 133 on the plurality of sub-pixel light-emitting function layers 12 covers the plurality of sub-pixel light-emitting function layers 12. That is to say, the adhesive glue layer 133 is provided as a whole layer, and an orthographic projection of the adhesive glue layer 133 on the first substrate 31 covers orthographic projections of the plurality of sub-pixel light-emitting function layers 12 on the first substrate 31. The adhesive glue layer 133 is made of a transparent organic adhesive material, and thus the adhesive glue layer 133 provided as a whole layer does not affect light emitted from the plurality of sub-pixel light-emitting function layers 12. In these embodiments, the adhesive glue layer 133 serves as the attaching layer 13, so that the transfer efficiency of Micro-LEDs may be improved, the thickness of the chip may be reduced, and the product yield may be improved.

A third embodiment (Embodiment 3) of a manufacturing method for a chip structure 10 is described below, according to which the chip structure 10 as shown in FIG. 3 is formed. In steps of manufacturing the chip structure 10, examples of a composition of the chip structure 10 can be understood by reference to FIG. 3 and the content as shown in the step diagram.

### Embodiment 3

For example, the steps of manufacturing the initial chip wafer unit 110 can be made by reference to steps S101 to S108, and the steps of manufacturing the color conversion layer unit 21 can be made by reference to steps R201 to R203, which are not repeated here.

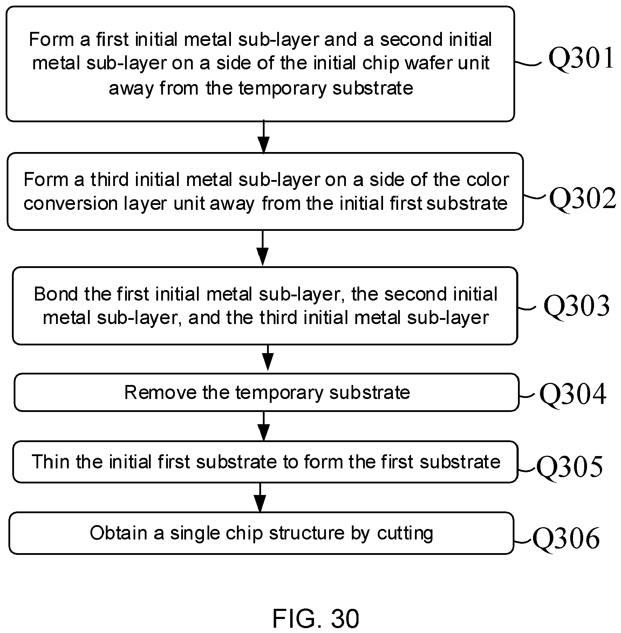

After the initial chip wafer unit 110 and the color conversion layer unit 21 are formed, the chip structure 10 is formed by assembling the color conversion layer unit 21 and the initial chip wafer unit 110 through the metal bonding layer 132 serving as the attaching layer 13. As shown in FIG. 30, steps include steps Q301 to Q306.

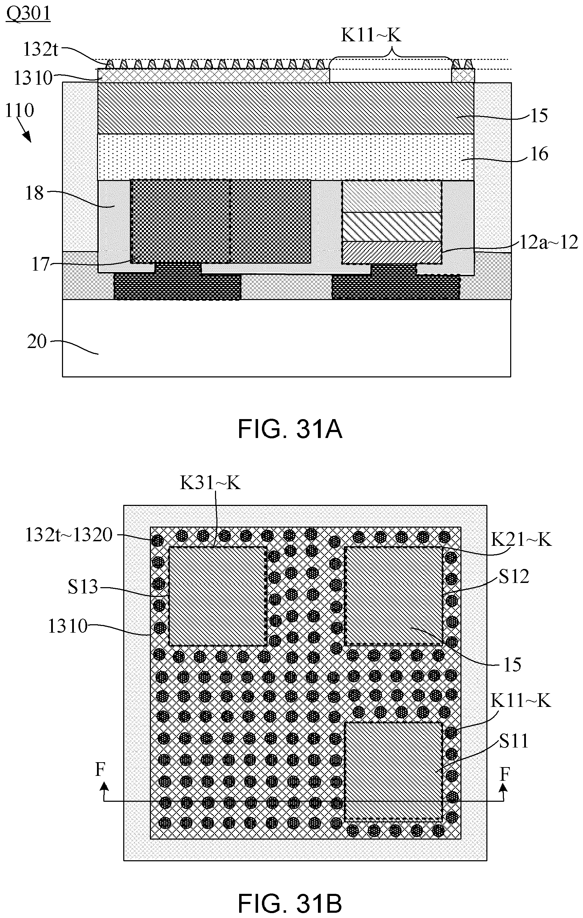

In Q301, as shown in FIG. 31A and FIG. 31B, a first initial metal sub-layer 1310 and a second initial metal sub-layer 1320 are formed on a side of the initial chip wafer unit 110 away from the temporary substrate 20.

That is, the first initial metal sub-layer 1310 and the second initial metal sub-layer 1320 are formed on a surface of the gallium nitride buffer layer 15 away from the temporary substrate 20. FIG. 31A is a cross-sectional view taken along the section line FF in FIG. 31B.

For example, a whole layer of a material for forming the first initial metal sub-layer 1310 is deposited on the surface of the gallium nitride buffer layer 15 away from the temporary substrate 20 by a deposition process, and the whole layer is patterned by a photolithography process to form the first initial metal sub-layer 1310, and the material of the first initial metal sub-layer 1310 may be any one of Au (Gold), Ag (Silver), Pb (Plumbum), and Sn (Stannum).

For example, as shown in FIG. 31B, the first initial metal sub-layer 1310 includes three opening zones K, and the three opening zones K are a first opening sub-zone K11, a second opening sub-zone K21 and a third opening sub-zone K31, respectively. The first opening sub-zone K11 is arranged to correspond to the first sub-pixel region S11, the second opening sub-zone K21 is arranged to correspond to the second sub-pixel region S12, and the third opening sub-zone K31 is arranged to correspond to the third sub-pixel region S13. Here, "A being arranged to correspond to B" means that orthographic projections of A and B on the temporary substrate 20 coincide or substantially coincide. For example, the first sub-opening zone K11 is arranged to correspond to the first sub-pixel region S11, which means that an orthographic projection of the first opening sub-zone K11 on the temporary substrate 20 coincides or substantially coincides with an orthographic projection of the first sub-pixel region S11 on the temporary substrate 20.

For example, as shown in FIG. 31A and FIG. 31B, the second initial metal sub-layer 1320 includes a plurality of first-type metal protrusions 132t, and each first-type metal protrusion 132t may have a cylindrical or conical structure.

A material of the second initial metal sub-layer 1320 may be In (Indium). A temperature at which Au and In form a eutectic alloy is 160 °C, a temperature at which Ag and In form a eutectic alloy is 180 °C, a temperature at which Pb and In form a eutectic alloy is 200 °C, and a temperature at which Sn and In form a eutectic alloy is 120 °C.

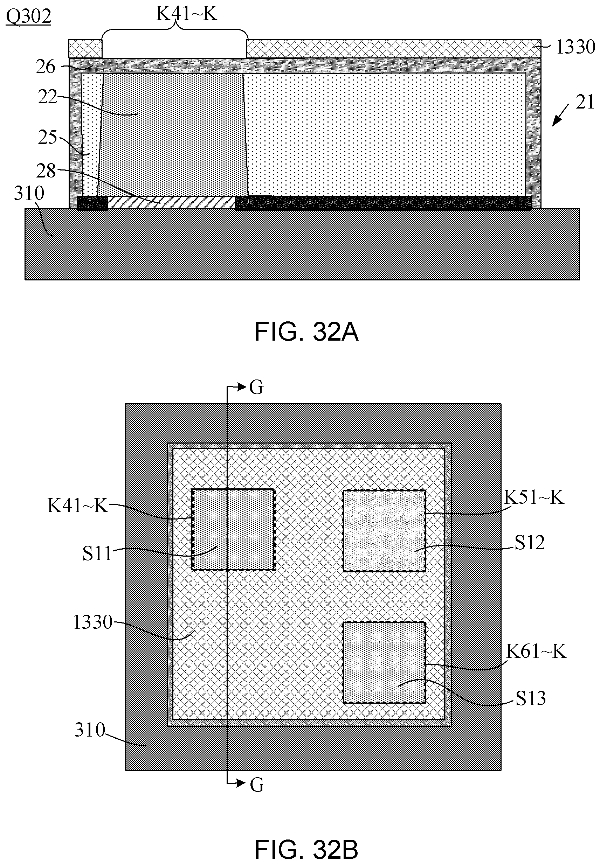

In Q302, as shown in FIG. 32A and FIG. 32B, a third initial metal sub-layer 1330 is formed on a side of the color conversion layer unit 21 away from the initial first substrate 310.

That is, the third initial metal sub-layer 1330 is formed on a surface of the inorganic encapsulation layer 26 away from the initial first substrate 310.

For example, a whole layer of a material for forming the third initial metal sub-layer 1330 is deposited on the surface of the inorganic encapsulation layer 26 away from the initial first substrate 310 by a deposition process, and the whole layer is patterned by a photolithography process to form the third initial metal sub-layer 1330, and the material of the third initial metal sub-layer 1330 may be any one of Au (Gold), Ag (Silver), Pb (Plumbum), and Sn (Stannum). The material of the third initial metal sub-layer 1330 may be the same as the material of the first initial metal sub-layer 1310.

For example, as shown in FIG. 32B, the third initial metal sub-layer 1330 includes three opening zones K, and the three opening zones K are a fourth opening sub-zone K41, a fifth opening sub-zone K51 and a sixth opening sub-zone K61, respectively. The fourth opening sub-zone K41 is arranged to correspond to the first sub-pixel region S11, the fifth opening sub-zone K51 is arranged to correspond to the second sub-pixel region S12, and the sixth opening sub-zone K61 is arranged to correspond to the third sub-pixel region S13.

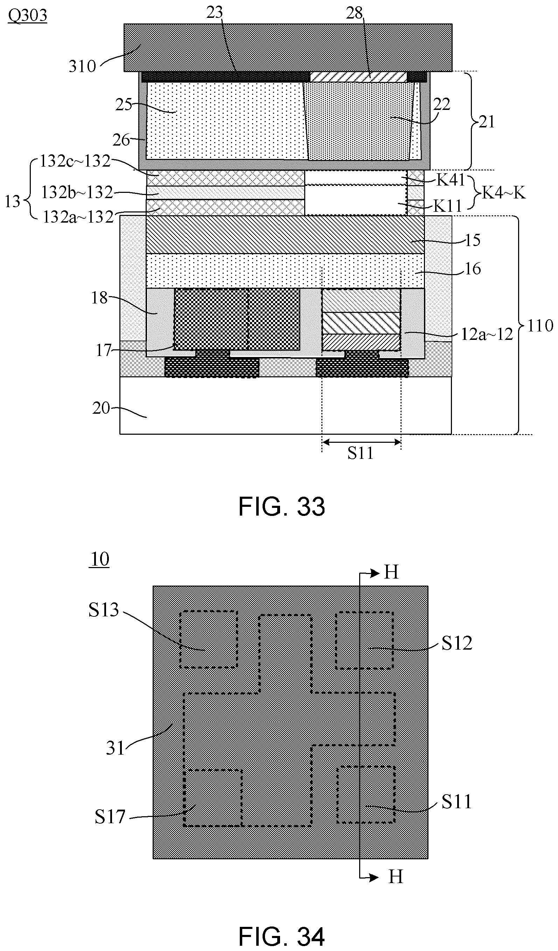

In Q303, as shown in FIG. 33, the first initial metal sub-layer 1310, the second initial metal sub-layer 1320, and the third initial metal sub-layer 1330 are bonded.

For example, bonding of the first initial metal sub-layer 1310, the second initial metal sub-layer 1320, and the third initial metal sub-layer 1330 is achieved by a metal wafer bonding technique. The metal wafer bonding technology refers to a technology of completely bonding two different metals at a temperature lower than their respective melting points by forming a eutectic alloy therebetween. The metal wafer bonding technology can be divided into a solid-liquid interdiffusion bonding technology and a solid diffusion bonding technology according to different bonding temperatures, in which the requirement of the solid-liquid interdiffusion bonding technology on a flatness of film layers is less than that of the solid-state diffusion bonding technology, and the solid-liquid interdiffusion bonding technology has high bonding strength and short bonding time. Therefore, the metal bonding layer 132 may be formed by using the solid-liquid interdiffusion bonding technique, so the color conversion layer unit 21 and the initial chip wafer unit 110 can be assembled.

As shown in FIG. 33, the metal bonding layer 132 is formed to include a first metal sub-layer 132a, a second metal sub-layer 132b, and a third metal sub-layer 132c. That is, the first initial metal sub-layer 1310, the second initial metal sub-layer 1320 and the third initial metal sub-layer 1330 form the metal bonding layer 132 through the metal wafer bonding technique, where the second metal sub-layer 132b is a eutectic alloy layer formed by a portion of the first initial metal sub-layer 1310, the second initial metal sub-layer 1320 and a portion of the third initial metal sub-layer 1330.

For example, as shown in FIG. 33, the metal bonding layer 132 includes a fourth opening zone K4, a fifth opening zone and a sixth opening zone, where the fourth opening zone K4 is arranged to correspond to the first sub-pixel region S11, the fifth opening zone is arranged to correspond to the second sub-pixel region S12, and the sixth opening zone is arranged to correspond to the third sub-pixel region S13. Arrangements of the second sub-pixel region S12 and the third sub-pixel region S13 can be made by reference to FIG. 32B. The first opening sub-zone K11 and the fourth opening sub-zone K41 form the fourth opening zone K4. Similarly, the second opening sub-zone K21 and the fifth opening sub-zone K51 form the fifth opening zone, and the third opening sub-zone K31 and the sixth opening sub-zone K61 form the sixth opening zone. Arrangements of the second opening sub-zone K21, the third opening sub-zone K31, the fifth opening sub-zone K51 and the sixth opening sub-zone K61 can be made by reference to FIG. 31B and FIG. 32B.

In Q304, the temporary substrate 20 is removed.

Specific steps can be made by reference to step T304, which is not repeated here.

In Q305, the initial first substrate 310 is thinned to form the first substrate 31.

Specific steps can be made by reference to step T305, which is not repeated here.

In Q306, a single chip structure 10 is obtained by cutting.

Specific steps can be made by reference to step T306, which is not repeated here.

The chip structure 10 shown in FIG. 3 is formed through the steps S101 to S108, the steps R201 to R203, and the steps Q301 to Q306. The attaching layer 13 is the metal bonding layer 132, opening zones K corresponding to the plurality of sub-pixel light-emitting function layers 12 need to be arranged in the metal bonding layer 132. It is because the metal bonding layer 132 is opaque, openings need to be arranged in regions of the metal bonding layer 132 corresponding to the sub-pixel light-emitting function layers 12 to allow light to pass therethrough. It will be noted that a region of the metal bonding layer 132 corresponding to a sub-pixel light-emitting function layer 12 is a region where orthographic projections of the sub-pixel light-emitting function layer 12 and the metal bonding layer 132 on the first substrate 31 overlap. In these embodiments, the metal bonding layer 132 serves as the attaching layer 13, so that the accuracy of the formed attaching layer 13 may be improved.

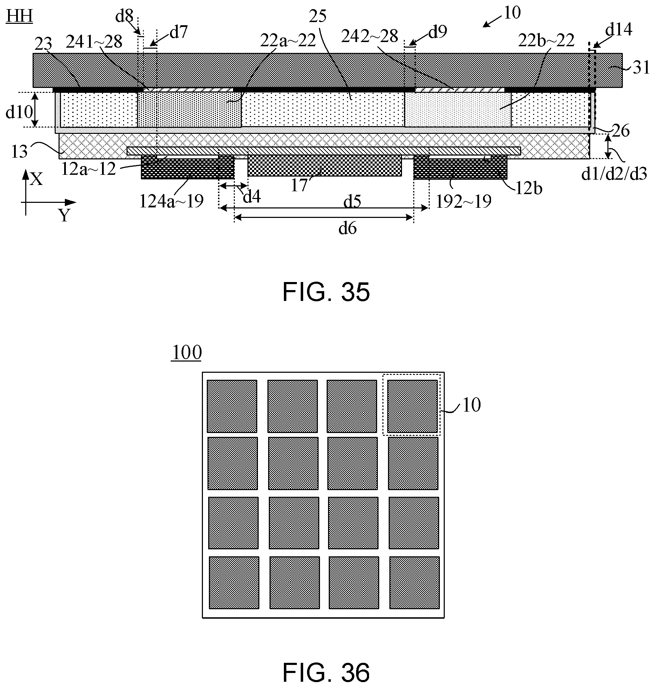

In some embodiments, as shown in FIG. 34 and FIG. 35, a distance d5 between two adjacent sub-pixel light-emitting function layers 12 in the plurality of sub-pixel light-emitting function layers 12 is in a range of 30 µm to 80 µm, inclusive.

For example, the distance d5 between two adjacent sub-pixel light-emitting function layers 12, for example, the distance d5 between the first sub-pixel light-emitting function layer 12a and the second sub-pixel light-emitting function layer 12b, is 30 µm, 40 µm, 50 µm, 60 µm, 70 µm, 75 µm, or 80 µm, which is not limited here. A too small distance d5 between two adjacent sub-pixel light-emitting function layers 12, for example, the distance d5 is less than 30 µm, may cause a cross color problem between the two adjacent sub-pixel light-emitting function layers 12, so the distance d5 between two adjacent sub-pixel light-emitting function layers 12 is in the range of 30 µm to 80 µm may effectively prevent the cross color while maintaining the brightness of the chip structure 10.

In combination with the above, as shown in FIG. 35, a dimension d1 of the indium zinc oxide bonding layer 131 in the first direction X is in a range of 100 nm to 300 nm, inclusive; a dimension d2 of the adhesive glue layer 133 in the first direction X is in a range of 5 µm to 10 µm, inclusive; and a dimension d3 of the metal bonding layer 132 in the first direction X is in a range of 6 µm to 12 µm, inclusive. The dimension (for example, the dimension d1, the dimension d2, or the dimension d3) of the attaching layer 13 in the first direction X is less than the distance d5 between two adjacent sub-pixel light-emitting function layers 12 in the plurality of sub-pixel light-emitting function layers 12, so that cross color interference between the sub-pixel light-emitting function layers 12 may be avoided, and the light-emitting effect of the chip structure 10 is improved.

In some embodiments, as shown in FIG. 34 and FIG. 35, in the plurality of anode electrodes, a distance d6 between two adjacent anode electrodes is less than or equal to the distance d5 between two sub-pixel light-emitting function layers 12 where the two anode electrodes are located.

For example, as shown in FIG. 35, the first sub-pixel light-emitting function layer 12a is arranged to correspond to a first anode 124a, the second sub-pixel light-emitting function layer 12b is arranged to correspond to a second anode 192, and the distance d6 between the first anode 124a and the second anode 192 is less than the distance d5 between the first sub-pixel light-emitting function layer 12a and the second sub-pixel emission function layer 12b.

Through setting the distance d6 between two adjacent anode electrodes less than or equal to the distance d5 between two sub-pixel light-emitting function layers 12 where the two anode electrodes are located, a border of an anode electrode exceeds a border of a sub-pixel light-emitting function layer 12 where the anode electrode is located, in this way, the anode electrode may have a great area to reflect light while having a switching function, thereby improving the light-emitting effect of chip structure 10.

It will be noted that as shown in FIG. 11B, a distance d13 between the cathode electrode 17b and an electrode 19 adjacent thereto may be set by reference to the distance d6 between the two adjacent anode electrodes, which is not repeated here.

For example, the distance d6 between two adjacent anode electrodes is in a range of 30 µm to 75 µm, inclusive. Anode electrodes include the first anode 124a, the second anode 192, and the third anode 193. For example, the distance d6 between two adjacent anodes, for example, the distance d6 between the first anode 124a and the second anode 192, is 30 µm, 35 µm, 40 µm, 45 µm, 50 µm, 55 µm, 65 µm, or 75 µm, which is not limited here.

In some embodiments, as shown in FIG. 34 and FIG. 35, an orthographic projection of a light-filtering film layer 28 on the first substrate 31 covers an orthographic projection of a sub-pixel light-emitting function layer 12 corresponding to the light-filtering film layer 28 on the first substrate 31; an orthographic projection of a color conversion layer 22 on the first substrate 31 covers an orthographic projection of a light-filtering film layer 28 corresponding to the color conversion layer 22 on the first substrate 31; and an orthographic projection of the scattering particle part 22b on the first substrate 31 covers an orthographic projection of the second light-filtering film 242 on the first substrate 31. FIG. 35 is a cross-sectional view taken along the section line HH in FIG. 34.

That is to say, in any direction, a dimension of an orthographic projection of a light-filtering film layer 28 on the first substrate 31 is greater than a dimension of an orthographic projection of a sub-pixel light-emitting function layer 12 corresponding to the light-filtering film layer 28 on the first substrate 31; a dimension of an orthographic projection of a color conversion layer 22 on the first substrate 31 is greater than a dimension of an orthographic projection of a light-filtering film layer 28 corresponding to the color conversion layer 22 on the first substrate 31; and a dimension of an orthographic projection of the scattering particle part 22b on the first substrate 31 is greater than a dimension of an orthographic projection of the second light-filtering film 242 on the first substrate 31.

For example, a distance d7 between a border of an orthographic projection of a light-filtering film layer 28 on the first substrate 31 and a border of an orthographic projection of a sub-pixel light-emitting function layer 12 corresponding to the light-filtering film layer 28 on the first substrate 31 is in a range of 20 µm to 60 µm, inclusive. For example, the distance d7 between the border of the orthographic projection of the light-filtering film layer 28 on the first substrate 31 and the border of the orthographic projection of the sub-pixel light-emitting function layer 12 corresponding to the light-filtering film layer 28 on the first substrate 31 is 20 µm, 40 µm, 50 µm, or 60 µm, which is not limited here.

For example, a distance d8 between a border of an orthographic projection of a color conversion layer 22 on the first substrate 31 and a border of an orthographic projection of a light-filtering film layer 28 corresponding to the color conversion layer 22 on the first substrate 31 is in a range of 23 µm to 68 µm, inclusive. For example, the distance d8 between the border of the orthographic projection of the color conversion layer 22 on the first substrate 31 and the border of the orthographic projection of the light-filtering film layer 28 corresponding to the color conversion layer 22 on the first substrate 31 is 23 µm, 30 µm, 35 µm, 42 µm, 50 µm, 60 µm, or 68 µm, which is not limited here.

For example, a distance d9 between a border of an orthographic projection of the scattering particle part 22b on the first substrate 31 and a border of an orthographic projection of the second light-filtering film 242 on the first substrate 31 is in a range of 23 µm to 68 µm, inclusive. For example, the distance d9 between the border of the orthographic projection of the scattering particle part 22b on the first substrate 31 and the border of the orthographic projection of the second light-filtering film 242 on the first substrate 31 is 23 µm, 32 µm, 38 µm, 45 µm, 55 µm, 62 µm, or 68 µm, which is not limited here.

In some embodiments, as shown in FIG. 34 and FIG. 35, a dimension d10 of the defining dam layer 25 in the first direction X is in a range of 10 µm to 30 µm, inclusive.

For example, the dimension d10 of the defining dam 25 in the first direction X is 10 µm, 15 µm, 20 µm, 25 µm, 28 µm, or 30 µm, which is not limited here. The dimension d10 of the defining dam layer 25 in the first direction X, i.e., a thickness thereof, is set to be 10 µm to 30 µm, the thickness of the defining dam layer 25 is increased; and a thickness of a color conversion layer 22 is synchronously increased because the color conversion layer 22 is arranged in the opening zone K of the defining dam layer 25, such design may improve the light-emitting effect of the chip structure 10.

In some embodiments, as shown in FIG. 35, an orthographic projection of the color conversion layer unit 21 on the first substrate 31 covers an orthographic projection of the attaching layer 13 on the first substrate 31.

For example, a material of the attaching layer 13 is an epoxy resin-based organic adhesive material; by arranging the orthographic projection of the color conversion layer unit 21 on the first substrate 31 to cover the orthographic projection of the attaching layer 13 on the first substrate 31, it can be ensured that no organic adhesive material remains at a position of the cutting channel 102 (shown in FIG. 4), which is convenient for forming the chip structure 10 by cutting.

In some examples, as shown in FIG. 35, a distance d14 between a border of an orthographic projection of the color conversion layer unit 21 on the first substrate 31 and a border of an orthographic projection of the attaching layer 13 on the first substrate 31 is in a range of 0 µm to 10 µm, inclusive.

For example, the distance d14 between the border of the orthographic projection of the color conversion layer unit 21 on the first substrate 31 and the border of the orthographic projection of the attaching layer 13 on the first substrate 31 is 0 µm, 2 µm, 5 µm, 7 µm, or 10 µm, which is not limited here.

By setting the distance d14 between the border of the orthographic projection of the color conversion layer unit 21 on the first substrate 31 and the border of the orthographic projection of the attaching layer 13 on the first substrate 31 to be 0 µm to 10 µm, it can be ensured that no organic adhesive material remains at the position of the cutting channel 102 (shown in FIG. 4) in a case that the material of the attaching layer 13 is an epoxy resin-based organic adhesive material while ensuring the attaching stability of the chip structure 10.

Some embodiments of the present disclosure provide a display substrate 100, as shown in FIG. 36, the display substrate 100 includes a plurality of chip structures 10 each according to any of the above embodiments.

In some embodiments, the display substrate 100 includes a driving backplane, and the driving backplane includes a circuit layer. The plurality of chip structures 10 are arranged on the driving backplane. The circuit layer includes, for example, a plurality of bonding pad groups, each bonding pad group includes a plurality of bonding pads arranged separately. In each chip structure 10, a cathode electrode 17b, a first anode 124a, a second anode 192, and a third anode 193 each are electrically connected to a respective bonding pad of the plurality of bonding pads.

For example, the plurality of chip structures 10 are transferred to the driving backplane by a mass transfer technique.

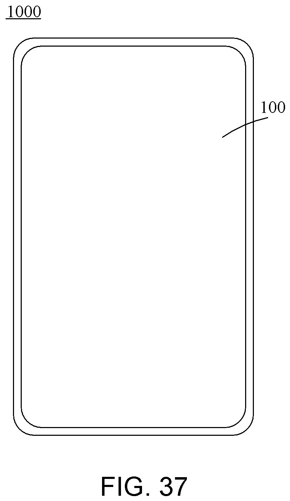

Some embodiments of the present disclosure provide a display device 1000, as shown in FIG. 37, the display device 1000 includes the display substrate 100 described above.

For example, the display device may be any device that can display an image whether in motion (e.g., a video) or stationary (e.g., a static image), and whether literal or graphical. More specifically, it is expected that the embodiments may be implemented in or associated with a plurality of electronic devices. The plurality of electronic devices may include (but is not limited to), for example, mobile telephones, wireless devices, personal data assistants (PDA), hand-held or portable computers, GPS receivers/navigators, cameras, MP4 video players, video cameras, game consoles, watches, clocks, calculators, TV monitors, flat panel displays, computer monitors, car displays (such as odometer displays, etc.), navigators, cockpit controllers and/or displays, camera view displays (such as rear view camera displays in vehicles), electronic photos, electronic billboards or indicators, projectors, building structures, packagings and aesthetic structures (such as a display for an image of a piece of jewelry) etc.

The foregoing descriptions are merely specific embodiments of the present disclosure, but the scope of protection of the present disclosure is not limited thereto. Any changes or replacements that a person skilled in the art could conceive of within the technical scope of the present disclosure shall be included in the protection scope of the present disclosure. Therefore, the protection scope of the present disclosure shall be subject to the protection scope of the claims.

## Claims

1. A chip structure, comprising: a chip wafer unit and a color conversion layer unit arranged on a light-exit side of the chip wafer unit, wherein the chip wafer unit includes: a plurality of sub-pixel light-emitting function layers, and the color conversion layer unit includes: color conversion layers arranged on the light-exit side of the chip wafer unit, and
further comprising: an attaching layer, arranged between the chip wafer unit and the color conversion layer unit and configured to attach the chip wafer unit and the color conversion layer unit.

2. The chip structure according to claim **1,** wherein the attaching layer is any one of an indium zinc oxide bonding layer, a metal bonding layer, and an adhesive glue layer.

3. The chip structure according to claim **1** or **2,** wherein a dimension of the attaching layer in a first direction is less than a distance between two adjacent sub-pixel light-emitting function layers in the plurality of sub-pixel light-emitting function layers, wherein
the first direction is a direction from the chip wafer unit to the color conversion layer unit.

4. The chip structure according to claim **3,** wherein the attaching layer is the indium zinc oxide bonding layer, and a dimension of the indium zinc oxide bonding layer in the first direction is in a range of 100 nm to 300 nm, inclusive; or
the attaching layer is the metal bonding layer, and a dimension of the metal bonding layer in the first direction is in a range of 6 µm to 12 µm, inclusive; or
the attaching layer is the adhesive glue layer, and a dimension of the adhesive glue layer in the first direction is in a range of 5 µm to 10 µm, inclusive.

5. The chip structure according to claim **3** or **4,** wherein the attaching layer is the indium zinc oxide bonding layer, and the indium zinc oxide bonding layer includes: a first indium zinc oxide layer and a second indium zinc oxide layer that are arranged in a stack along the first direction, the first indium zinc oxide layer being connected to the second indium zinc oxide layer through a bonding interaction of molecular bonds; or
the attaching layer is the metal bonding layer, and the metal bonding layer includes: a first metal sub-layer, a second metal sub-layer, and a third metal sub-layer that are arranged in a stack along the first direction, the second metal sub-layer being a eutectic alloy layer connecting the first metal sub-layer and the third metal sub-layer.

6. The chip structure according to any one of claims **2** to **5,** wherein the attaching layer is the indium zinc oxide bonding layer, and an orthographic projection of the indium zinc oxide bonding layer on the plurality of sub-pixel light-emitting function layers covers the plurality of sub-pixel light-emitting function layers; or
the attaching layer is the metal bonding layer, and the metal bonding layer is provided therein with opening zones corresponding to the plurality of sub-pixel light-emitting function layers; or
the attaching layer is the adhesive glue layer, and an orthographic projection of the adhesive glue layer on the plurality of sub-pixel light-emitting function layers covers the plurality of sub-pixel light-emitting function layers.

7. The chip structure according to any one of claims **2** to **6,** wherein the chip structure further comprises: a first substrate, wherein the first substrate is arranged on a side of the color conversion layer unit away from the chip wafer unit, and an orthographic projection of the color conversion layer unit on the first substrate covers an orthographic projection of the attaching layer on the first substrate.

8. The chip structure according to claim **7,** wherein a distance between a border of the orthographic projection of the color conversion layer unit on the first substrate and a border of the orthographic projection of the attaching layer on the first substrate is in a range of 0 µm to 10 µm, inclusive.

9. The chip structure according to any one of claims **1** to **8,** wherein each sub-pixel light-emitting function layer of the plurality of sub-pixel light-emitting function layers includes: an anode electrode, a current spreading layer, a p-type gallium nitride layer, and a quantum well layer that are arranged in a stack along a first direction;
the chip wafer unit further includes: a common cathode layer, wherein the common cathode layer includes: a cathode electrode and a cathode metal layer that are arranged in a stack along the first direction, wherein
the cathode metal layer further includes: portions each located between two adjacent sub-pixel light-emitting function layers, first direction being a direction from the chip wafer unit to the color conversion layer unit.

10. The chip structure according to claim **9,** wherein a portion of the cathode metal layer located between two adjacent sub-pixel light-emitting function layers and the two adjacent sub-pixel light-emitting function layers have a distance therebetween; and
the distance between the sub-pixel light-emitting function layers and the cathode metal layer is in a range of one tenth (1/10) to one third (1/3) of a distance between the two adjacent sub-pixel light-emitting function layers, inclusive.

11. The chip structure according to claim **9** or **10,** wherein in a plurality of anode electrodes, a range of a distance between two adjacent anode electrodes is less than or equal to a range of a distance between two sub-pixel light-emitting function layers where the two anode electrodes are located.

12. The chip structure according to any one of claims **1** to **11,** wherein the chip wafer unit further includes: an n-type gallium nitride layer and a gallium nitride buffer layer that are arranged in a stack along a first direction; and the n-type gallium nitride layer is arranged on a light-exit side of the plurality of sub-pixel light-emitting function layers; and
the attaching layer is arranged on a side of the gallium nitride buffer layer away from the n-type gallium nitride layer, the first direction being a direction from the chip wafer unit to the color conversion layer unit.

13. The chip structure according to any one of claims **1** to **12,** wherein the plurality of sub-pixel light-emitting function layers include: a first sub-pixel light-emitting function layer, a second sub-pixel light-emitting function layer, and a third sub-pixel light-emitting function layer;
the chip structure further comprises: a first substrate, and the color conversion layer unit includes: a color filter layer arranged on a side of the first substrate, the color filter layer including:
a black matrix layer and a plurality of light-filtering film layers defined by the black matrix layer, the plurality of light-filtering film layers including:
a first light-filtering film layer, a second light-filtering film layer, and a third light-filtering film layer, wherein the first light-filtering film layer is arranged to correspond to the first sub-pixel light-emitting function layer, the second light-filtering film layer is arranged to correspond to the second sub-pixel light-emitting function layer, and the third light-filtering film layer is arranged to correspond to the third sub-pixel light-emitting function layer;
the color conversion layer unit further includes: a defining dam layer arranged on a side of the color filter layer away from the first substrate, the defining dam layer including:
a plurality of opening zones, the plurality of opening zones including:
a first opening zone, a second opening zone, and a third opening zone, wherein the first opening zone is arranged to correspond to the first sub-pixel light-emitting function layer, the second opening zone is arranged to correspond to the second sub-pixel light-emitting function layer, and the third opening zone is arranged to correspond to the third sub-pixel light-emitting function layer; and
the color conversion layers further include: a first quantum dot conversion part, a second quantum dot conversion part and a scattering particle part, wherein the first quantum dot conversion part is arranged in the first opening zone, the scattering particle part is arranged in the second opening zone, and the second quantum dot conversion part is arranged in the third opening zone.

14. The chip structure according to claim **13,** wherein
an orthographic projection of a light-filtering film layer on the first substrate covers an orthographic projection of a sub-pixel light-emitting function layer corresponding to the light-filtering film layer on the first substrate;
an orthographic projection of a quantum dot conversion part on the first substrate covers an orthographic projection of a light-filtering film layer corresponding to the quantum dot conversion part on the first substrate; and
an orthographic projection of the scattering particle part on the first substrate covers an orthographic projection of the second light-filtering film layer on the first substrate.

15. The chip structure according to claim **14,** wherein
a distance between a border of the orthographic projection of the light-filtering film layer on the first substrate and a border of the orthographic projection of the sub-pixel light-emitting function layer corresponding to the light-filtering film layer on the first substrate is in a range of 20 µm to 60 µm, inclusive;
a distance between a border of the orthographic projection of the quantum dot conversion part on the first substrate and a border of the orthographic projection of the light-filtering film layer corresponding to the quantum dot conversion part on the first substrate is in a range of 23 µm to 68 µm, inclusive; and
a distance between a border of the orthographic projection of the scattering particle part on the first substrate and a border of the orthographic projection of the second light-filtering film layer on the first substrate is in a range of 23 µm to 68 µm, inclusive.

16. The chip structure according to any one of claims **13** to **15,** wherein a dimension of the defining dam layer in a first direction is in a range of 10 µm to 30 µm, inclusive, wherein
the first direction is a direction from the chip wafer unit to the color conversion layer unit.

17. A manufacturing method for a chip structure, the manufacturing method comprising:
forming an initial chip wafer unit, wherein the initial chip wafer unit includes a temporary substrate, a plurality of sub-pixel light-emitting function layers, an n-type gallium nitride layer, and a gallium nitride buffer layer that are arranged in a stack;
forming a color conversion layer unit on an initial first substrate; and
attaching the color conversion layer unit to a light-exit side of the initial chip wafer unit to obtain the chip structure.

18. The manufacturing method for the chip structure according to claim **17,** wherein a step of attaching the color conversion layer unit to a light-exit side of the initial chip wafer unit includes:
forming a first indium zinc oxide layer on a side of the initial chip wafer unit away from the temporary substrate;
forming a second indium zinc oxide layer on a side of the color conversion layer unit away from the initial first substrate; and
bonding the first indium zinc oxide layer and the second indium zinc oxide layer to form an attaching layer connecting the initial chip wafer unit and the color conversion layer unit; or
the step of attaching the color conversion layer unit to a light-exit side of the initial chip wafer unit includes:
forming a first initial metal sub-layer and a second initial metal sub-layer on a side of the initial chip wafer unit away from the temporary substrate, wherein the second initial metal sub-layer is composed of a plurality of first-type metal protrusions formed on a side of the first initial metal sub-layer away from the temporary substrate;
form ing a third initial metal sub-layer on a side of the color conversion layer unit away from the initial first substrate; and
bonding the first initial metal sub-layer, the second initial metal sub-layer, and the third initial metal sub-layer to form an attaching layer connecting the initial chip wafer unit and the color conversion layer unit; or
the step of attaching the color conversion layer unit to a light-exit side of the initial chip wafer unit includes:
connecting the initial chip wafer unit and the color conversion layer unit by using an adhesive glue.

19. The manufacturing method for the chip structure according to claim **18,** wherein a step of bonding the first indium zinc oxide layer and the second indium zinc oxide layer includes:
treating a surface of the first indium zinc oxide layer away from the temporary substrate by adopting oxygen plasma;
treating a surface of the second indium zinc oxide layer away from the initial first substrate by adopting oxygen plasma; and
pressing the first indium zinc oxide layer and the second indium zinc oxide layer under a temperature condition of 150 °C to 240 °C, inclusive, so as to form the attaching layer.

20. The manufacturing method for the chip structure according to any one of claims **17** to **19,** wherein after the step of attaching the color conversion layer unit to a light-exit side of the initial chip wafer unit, the manufacturing method comprises:
removing the temporary substrate to form a chip wafer unit; and
thinning the initial first substrate to form a first substrate, so as to obtain the chip structure.

21. A display substrate, comprising the chip structure according to any one of claims **1** to **16.**

22. A display device, comprising the display substrate according to claim **21.**
